# EUROPEAN PATENT SPECIFICATION

(11) **EP 4 329 141 B1**
(45) Date of publication and mention of the grant of the patent: **08.10.2025**
(21) Application number: 23804566.0
(22) Date of filing: 21.04.2023
(51) Int. Cl.: H02J 7/00, H01M 10/44

(54) **MULTI-BATTERY POWER SUPPLY, CHARGING/DISCHARGING METHOD, AND ELECTRONIC DEVICE**
MEHRBATTERIE-STROMVERSORGUNG, LADE-/ENTLADEVERFAHREN UND ELEKTRONISCHE VORRICHTUNG
ALIMENTATION ÉLECTRIQUE À PLUSIEURS BATTERIES, PROCÉDÉ DE CHARGE/DÉCHARGE ET DISPOSITIF ÉLECTRONIQUE

(30) Priority: 06.07.2022 CN 202210790144
(43) Date of publication of application: 28.02.2024
(73) Proprietor: Honor Device Co., Ltd., Shenzhen, Guangdong 518040 (CN)
(72) Inventor: CAO, Lei, Shenzhen, Guangdong 518040 (CN); ZHU, Chen, Shenzhen, Guangdong 518040 (CN); QIU, Yupeng, Shenzhen, Guangdong 518040 (CN)
(74) Representative: Maiwald GmbH
(86) International application number: PCT/CN2023/089857
(87) International publication number: WO 2024/007687

(56) References cited:
- EP-A1- 1 569 316
- CN-A- 111 864 843
- CN-A- 111 900 769
- CN-A- 114 844 182
- CN-A- 114 859 258
- CN-A- 114 865 755
- US-A1- 2020 259 342
- US-A1- 2022 140 621
- US-A1- 2022 181 890

## Description

This application claims priority to Chinese Patent Application No. 202210790144.6, entitled "MULTI-BATTERY POWER SUPPLY, CHARGING/DISCHARGING METHOD, AND ELECTRONIC DEVICE", and filed with the China National Intellectual Property Administration on July 6, 2022.

### TECHNICAL FIELD

This application relates to the field of power supply technologies, and in particular, to a multi-battery power supply, a charging/discharging method, and an electronic device.

### BACKGROUND

Limited by electronic device frames and other factors, a plurality of batteries in small-sized electronic devices such as mobile phones usually have different capacities. In addition, the small-sized electronic devices have limited spaces for batteries, leading to limited battery sizes, resulting in limited battery capacities. Therefore, battery capacity resources are precious. In the prior art, during charging of batteries with different capacities at the same time, loss of battery capacity is caused, wasting precious battery capacity resources. How to charge a plurality of batteries with different capacities and reduce the loss of battery capacity is a problem to be resolved.

United States patent application US 2020/0259342 A1 describes a battery supply circuit including a first cell, a second cell, a switch, a first switching unit and a second switching unit.

United States patent application US 2022/0181890 A1 describes a charging system including a voltage conversion circuit, a control circuit, an input end and an output end.

United States patent application US 2022/0140621 A1 describes a charging integrated circuit including a connection circuit configured to selectively connect a first battery and a second battery to each other in series and in parallel.

### SUMMARY

Embodiments of this application provide a charging circuit, a charging method, and an electronic device, which can charge batteries with different capacities at the same time, and enable a plurality of batteries to be fully charged at the same time without decreasing a charging speed, thereby avoiding loss of battery capacities and saving battery capacity resources.

The invention is set out in the appended set of claims.

The embodiments of this application provide a multi-battery power supply, a charging/discharging method, and an electronic device. To charge a battery pack, two batteries are connected in series, so that two batteries with different capacities can be fully charged at the same time. When batteries supply power to the outside, two batteries are connected in parallel to avoid efficiency loss caused by power conversion.

To achieve the foregoing objective, the following technical solutions are used in the embodiments of this application:

According to a first aspect, a power supply circuit is provided, configured to charge/discharge a battery pack. The battery pack includes a first battery and a second battery. The power supply circuit includes a first circuit, a second circuit, a first switch, and a second switch. The first circuit has one end coupled to a power supply terminal of a charger and another end coupled to a positive electrode of the first battery. A negative electrode of the first battery is coupled to a first controlled terminal of the second switch. A first controlled terminal of the first switch is coupled to the positive electrode of the first battery. A second controlled terminal of the first switch is coupled to a second controlled terminal of the second switch and a positive electrode of the second battery. A third controlled terminal of the second switch is coupled to a negative electrode of the second battery. The second circuit has one end coupled to the power supply terminal of the charger and another end coupled to the positive electrode of the second battery. When the first switch is off, the first controlled terminal of the second switch is electrically connected to the second controlled terminal of the second switch, the first controlled terminal of the second switch is electrically disconnected from the third controlled terminal of the second switch, and when the first circuit is on, the first circuit and the second circuit are configured to supply power to the battery pack. When the first switch is on, the first controlled terminal of the second switch is electrically disconnected from the second controlled terminal of the second switch, the first controlled terminal of the second switch is electrically connected to the third controlled terminal of the second switch, and when the first circuit is off, the battery pack supplies power to the outside through the second circuit.

In this implementation, switching between the first switch and the second switch is performed, so that during charging of the battery pack, two batteries are connected in series, and the first circuit and the second circuit jointly charge a battery 1 and a battery 2. In this way, a ratio of a charging current value of the battery 1 to a charging current value of the battery 2 is equal to a ratio of a capacity of the battery 1 to a capacity of the battery 2, so that the battery 1 and the battery 2 are fully charged at the same time. When the battery pack supplies power to a system, the two batteries are connected in parallel, and a supply voltage of the battery is equal to a rated supply voltage of the system, thereby avoiding an efficiency loss caused by power conversion by a discharging circuit and avoiding a waste of battery capacities.

According to the first aspect, a capacity of the first battery is a first value, a capacity of the second battery is a second value, and the first value is less than the second value. When the first switch is off, the first controlled terminal of the second switch is electrically connected to the second controlled terminal of the second switch, the first controlled terminal of the second switch is electrically disconnected from the third controlled terminal of the second switch, and when the first circuit is on, the first circuit is configured to input a first charging current to the first battery. The first charging current of the first battery is output to the second battery. The second circuit is configured to input a second charging current to the second battery. A ratio of the first charging current input to the first battery to a third charging current input to the second battery is equal to a ratio of the first value to the second value. The third charging current is a sum of the first charging current and the second charging current.

According to a first aspect, in a possible implementation, a value of the first charging current is a first current value, the power supply circuit further includes a sampling circuit, one end of the sampling circuit is coupled to the negative electrode of the first battery, and another end of the sampling circuit is coupled to the first controlled terminal of the second switch. The sampling circuit is configured to detect a detection value of the first charging current. The first circuit is further configured to adjust an output current based on the detection value of the first charging current and the first current value, so that the value of the first charging current is the first current value.

In this implementation, the sampling circuit is used to obtain the value of the charging current of the first battery in real time and adjust the output current of the first circuit, where if a current value of the first charging current is less than a preset first current value, the output current of the first circuit is increased; or if a current value of the first charging current is greater than a preset first current value, the output current of the first circuit is reduced, so that the value of the first charging current is equal to the preset first current value.

According to a first aspect, in a possible implementation, the first circuit is a direct charging circuit, and the second circuit is a buck circuit.

According to a second aspect, an electronic device is provided, including: a first circuit, a second circuit, a first switch, a second switch, and a battery pack. The battery pack includes a first battery and a second battery. The first circuit has one end coupled to a power supply terminal of a charger and another end coupled to a positive electrode of the first battery. A negative electrode of the first battery is coupled to a first controlled terminal of the second switch. A first controlled terminal of the first switch is coupled to the positive electrode of the first battery. A second controlled terminal of the first switch is coupled to a second controlled terminal of the second switch and a positive electrode of the second battery. A third controlled terminal of the second switch is coupled to a negative electrode of the second battery. The second circuit has one end coupled to the power supply terminal of the charger and another end coupled to the positive electrode of the second battery. When the first switch is off, the first controlled terminal of the second switch is electrically connected to the second controlled terminal of the second switch, the first controlled terminal of the second switch is electrically disconnected from the third controlled terminal of the second switch, and when the first circuit is on, the first circuit and the second circuit are configured to supply power to the battery pack. When the first switch is on, the first controlled terminal of the second switch is electrically disconnected from the second controlled terminal of the second switch, the first controlled terminal of the second switch is electrically connected to the third controlled terminal of the second switch, and when the first circuit is off, the battery pack supplies power to a system of the electronic device through the second circuit.

In this implementation, switching between the first switch and the second switch is performed, so that during charging of the battery pack, two batteries are connected in series, and the first circuit and the second circuit jointly charge a battery 1 and a battery 2. In this way, a ratio of a charging current value of the battery 1 to a charging current value of the battery 2 is equal to a ratio of a capacity of the battery 1 to a capacity of the battery 2, so that the battery 1 and the battery 2 are fully charged at the same time. When the battery pack supplies power to a system, the two batteries are connected in parallel, and a supply voltage of the battery is equal to a rated supply voltage of the system, thereby avoiding an efficiency loss caused by power conversion by a discharging circuit and avoiding a waste of battery capacities.

According to the second aspect, a capacity of the first battery is a first value, a capacity of the second battery is a second value, and the first value is less than the second value. When the first switch is off, the first controlled terminal of the second switch is electrically connected to the second controlled terminal of the second switch, the first controlled terminal of the second switch is electrically disconnected from the third controlled terminal of the second switch, and when the first circuit is on, the first circuit is configured to input a first charging current to the first battery. The first charging current of the first battery is output to the second battery. The second circuit is configured to input a second charging current to the second battery. A ratio of the first charging current input to the first battery to a third charging current input to the second battery is equal to a ratio of the first value to the second value. The third charging current is a sum of the first charging current and the second charging current.

According to a second aspect, in a possible implementation, a value of the first charging current is a first current value, and a value of the second charging current is a second current value. The electronic device further includes a controller, configured to send the first current value to the first circuit; and further configured to send the second current value to the second circuit.

In this implementation, the controller controls a ratio of the charging currents of the first circuit and the second circuit.

According to a second aspect, in a possible implementation, the electronic device further includes a sampling circuit. One end of the sampling circuit is coupled to the negative electrode of the first battery. The other end of the sampling circuit is coupled to the first controlled terminal of the second switch. The sampling circuit is in communication connection with the first circuit through the controller. The sampling circuit is configured to detect a detection value of the first charging current. The first circuit is further configured to adjust an output current based on the detection value of the first charging current and the first current value, so that the value of the first charging current is the first current value.

In this implementation, the sampling circuit is used to obtain the value of the charging current of the first battery in real time and adjust the output current of the first circuit, where if a current value of the first charging current is less than a preset first current value, the output current of the first circuit is increased; or if a current value of the first charging current is greater than a preset first current value, the output current of the first circuit is reduced, so that the value of the first charging current is equal to the preset first current value.

According to a second aspect, in a possible implementation, a value of the first charging current is a first current value. The electronic device further includes a controller and a sampling circuit. One end of the sampling circuit is coupled to the negative electrode of the first battery. The other end of the sampling circuit is coupled to the first controlled terminal of the second switch. The sampling circuit is configured to detect a detection value of the first charging current. The sampling circuit is further configured to send the detection value of the first charging current to the controller. The controller is configured to control, based on the detection value of the first charging current and the first current value, the first circuit to adjust an output current, so that the value of the first charging current is the first current value.

According to a second aspect, in a possible implementation, the electronic device includes a controller, configured to: when determining to supply power to the battery pack, control the first switch to be off, control the first controlled terminal of the second switch to be electrically connected to the second controlled terminal of the second switch, control the first controlled terminal of the second switch to be electrically disconnected from the third controlled terminal of the second switch, and control the first circuit to be on. The controller is further configured to: when determining that the battery pack supplies power to the system of the electronic device, control the first switch to be on, control the first controlled terminal of the second switch to be electrically disconnected from the second controlled terminal of the second switch, control the first controlled terminal of the second switch to be electrically connected to the third controlled terminal of the second switch, and control the first circuit to be off.

According to a second aspect, in a possible implementation, the first circuit is a direct charging circuit, and the second circuit is a buck circuit.

According to a third aspect, a control method is provided, applied to an electronic device. The electronic device includes a first circuit, a second circuit, a first switch, a second switch, a controller, and a battery pack. The battery pack includes a first battery and a second battery. The first circuit has one end coupled to a power supply terminal of a charger and another end coupled to a positive electrode of the first battery. A negative electrode of the first battery is coupled to a first controlled terminal of the second switch. A first controlled terminal of the first switch is coupled to the positive electrode of the first battery. A second controlled terminal of the first switch is coupled to a second controlled terminal of the second switch and a positive electrode of the second battery. A third controlled terminal of the second switch is coupled to a negative electrode of the second battery. The second circuit has one end coupled to the power supply terminal of the charger and another end coupled to the positive electrode of the second battery. The method includes: The controller determines that the electronic device is connected to the charger, controls the first switch to be off, controls the first controlled terminal of the second switch to be electrically connected to the second controlled terminal of the second switch, controls the first controlled terminal of the second switch to be electrically disconnected from the third controlled terminal of the second switch, and controls the first circuit to be on. The controller sends a first current value to the first circuit, and sends a second current value to the second circuit. The first circuit inputs a first charging current to the first battery. The first charging current of the first battery is output to the second battery. A value of the first charging current is the first current value. The second circuit inputs a second charging current to the second battery. A value of the second charging current is the second current value. A value of a third charging current input to the second battery is a third current value. The third current value is a sum of the first current value and the second current value. A ratio of the first current value to the third current value is equal to a ratio of a first value to a second value.

In this method, the controller controls switching between the first switch and the second switch, so that during charging of the battery pack, two batteries are connected in series, and the first circuit and the second circuit jointly charge a battery 1 and a battery 2. In this way, a ratio of a charging current value of the battery 1 to a charging current value of the battery 2 is equal to a ratio of a capacity of the battery 1 to a capacity of the battery 2, so that the battery 1 and the battery 2 are fully charged at the same time.

According to the fourth aspect, in a possible implementation, the electronic device further includes a sampling circuit. One end of the sampling circuit is coupled to the negative electrode of the first battery. The other end of the sampling circuit is coupled to the first controlled terminal of the second switch. The method further includes: The sampling circuit detects a detection value of the first charging current, and sends the detection value of the first charging current to the controller. The controller controls, based on the detection value of the first charging current and the first current value, the first circuit to adjust an output current, so that the value of the first charging current is the first current value.

In this method, the controller uses the sampling circuit to obtain the value of the charging current of the first battery in real time and controls the first circuit to adjust the output current, where if a current value of the first charging current is less than a preset first current value, the output current of the first circuit is increased; or if a current value of the first charging current is greater than a preset first current value, the output current of the first circuit is reduced, so that the value of the first charging current is equal to the preset first current value.

According to the third aspect, in a possible implementation, the method further includes: The controller determines that the electronic device is electrically disconnected from the charger, controls the first switch to be on, controls the first controlled terminal of the second switch to be electrically disconnected from the second controlled terminal of the second switch, controls the first controlled terminal of the second switch to be electrically connected to the third controlled terminal of the second switch, and controls the first circuit to be off. The first battery and the second battery supply power to a system of the electronic device through the second circuit.

In this method, the controller controls switching between the first switch and the second switch, so that when the battery pack supplies power to the system, the two batteries are connected in parallel, and a supply voltage of the battery is equal to a rated supply voltage of the system, thereby avoiding an efficiency loss caused by power conversion by a discharging circuit and avoiding a waste of battery capacities.

### BRIEF DESCRIPTION OF DRAWINGS

FIG. 1 is a schematic architectural diagram of a charging system useful for understanding this application;
FIG. 2 is a schematic architectural diagram of another charging system useful for understanding this application;
FIG. 3 is a schematic diagram of a hardware structure of an electronic device useful for understanding this application;
FIG. 4 is a schematic diagram of a charging circuit;
FIG. 5 is a schematic diagram of another charging circuit;
FIG. 6 is a schematic diagram of a charging circuit useful for understanding this application;
FIG. 7 is a schematic diagram of a charging circuit useful for understanding this application;
FIG. 8 is a schematic flowchart of a charging method according to an embodiment of this application;
FIG. 9 is a schematic diagram of a charging circuit useful for understanding this application;
FIG. 10 is a schematic diagram of a charging circuit useful for understanding this application;
FIG. 11 is a schematic flowchart of a charging method according to an embodiment of this application;
FIG. 12 is a schematic diagram of a discharging circuit useful for understanding this application;
FIG. 13 is a schematic diagram of a charging/discharging circuit according to an embodiment of this application;
FIG. 14 is a schematic diagram of a charging circuit according to an embodiment of this application;
FIG. 15 is a schematic diagram of a discharging circuit according to an embodiment of this application;
FIG. 16 is a schematic diagram of a charging/discharging circuit according to an embodiment of this application;
FIG. 17 is a schematic diagram of a charging/discharging circuit according to an embodiment of this application;
FIG. 18 is a schematic diagram of a charging/discharging circuit according to an embodiment of this application;
FIG. 19 is a schematic structural diagram of a switch according to an embodiment of this application;
FIG. 20 is a schematic structural diagram of a switch according to an embodiment of this application;
FIG. 21 is a schematic flowchart of a charging/discharging method according to an embodiment of this application;
FIG. 22 is a schematic diagram of a charging/discharging circuit according to an embodiment of this application;
FIG. 23 is a schematic diagram of a coulometer useful for understanding this application;
FIG. 24 is a schematic diagram of a coulometer useful for understanding this application;
FIG. 25 is a schematic diagram of a coulometer useful for understanding this application;
FIG. 26 is a schematic diagram of a coulometer useful for understanding this application;
FIG. 27 is a schematic diagram of a coulometer useful for understanding this application;
FIG. 28 is a schematic diagram of an electronic device according to an embodiment of this application; and
FIG. 29 is a schematic structural diagram of a chip system useful for understanding this application.

### DESCRIPTION OF EMBODIMENTS

In descriptions of the embodiments of this application, terms used in the following embodiments are only intended to describe particular embodiments, and are not intended to limit this application. As used in this specification and the claims of this application, a singular expression form, "a", "the", "foregoing", "the", or "this", is intended to also include a "one or more" expression form, unless clearly indicated to the contrary in the context. It should be further understood that, in the following embodiments of this application, "at least one" and "one or more" mean one, two or more than two. The term "and/or" is used to describe an association relationship between associated objects and represents that three relationships may exist. For example, A and/or B may represent: only A exists, both A and B exist, and only B exists, where A and B may be singular or plural. The character "/" generally indicates that the associated objects are in an "or" relationship.

Reference to "one embodiment" or "some embodiments" described in this specification means that a specific characteristic, structure or feature described in combination with this embodiment is included in one or more embodiments of this application. Therefore, the statements "in one embodiment", "in some embodiments", "in some other embodiments", "in further embodiments", and the like in different places in this specification do not necessarily refer to the same embodiment, but mean "one or more but not all embodiments", unless otherwise specially emphasized in other ways. The terms "include", "contain", "have" and their variations mean "including but not limited to", unless otherwise specially emphasized in other ways. The term "connection" includes a direct connection and an indirect connection, unless otherwise specified. The terms "first" and "second" are used for descriptive purposes only and should not be construed as indicating or implying relative importance or implicitly indicating a quantity of technical features indicated.

In the embodiments of this application, the word "exemplary" or "for example" is used to represent giving an example, an illustration, or a description. Any embodiment or design scheme described as "exemplary" or "for example" in the embodiments of this application should not be explained as being more preferred or having more advantages than another embodiment or design scheme. In particular, the word such as "exemplary" or "for example" as used herein is intended to present a related concept in a specific manner.

In the embodiments of this application, the terms "couple" or "connection" should be understood in a broad sense. For example, the connection may be a physically direct connection, or an indirect connection realized through an electronic device, such as a connection realized through a resistor, an inductor, a capacitor, or other electronic devices.

A battery capacity represents an amount of electricity that a battery can deliver under some conditions (such as, discharge rate, temperature, or termination voltage). For example, a length of time for which the battery can discharge at a specified current is a capacity of the battery, usually measured in Ampere hours (expressed in A·h). For example, a battery with a capacity of 5A-h can work for approximately five hours when discharging at a current of 1 A.

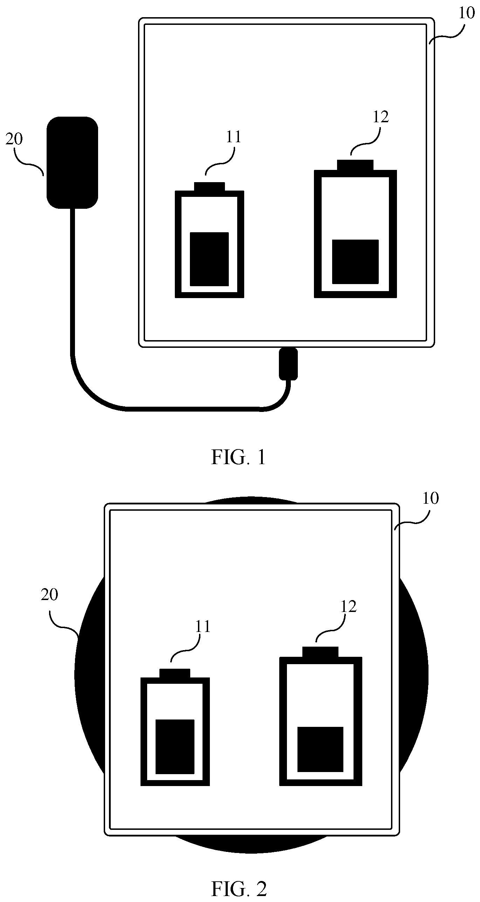

Currently, a plurality of batteries in small-sized electronic devices such as mobile phones usually have different capacities. For example, as shown in FIG. 1 and FIG. 2, an electronic device 10 includes a battery 11 and a battery 12. The battery 11 and the battery 12 have different battery capacities. In an example, a capacity of the battery 11 is less than that of the battery 12. For example, the capacity of the battery 11 is 2000 milliampere-hours (mA·h), and the capacity of the battery 12 is 3000 mA·h. It should be noted that in this embodiment of this application, that the electronic device 10 includes the battery 11 and the battery 12 is used as an example for description. It may be understood that, the electronic device 10 may further include a larger quantity of batteries. When a larger quantity of batteries are included, an implementation principle is similar to that of the case of including the battery 11 and the battery 12, and examples are not listed one by one in this embodiment of this application.

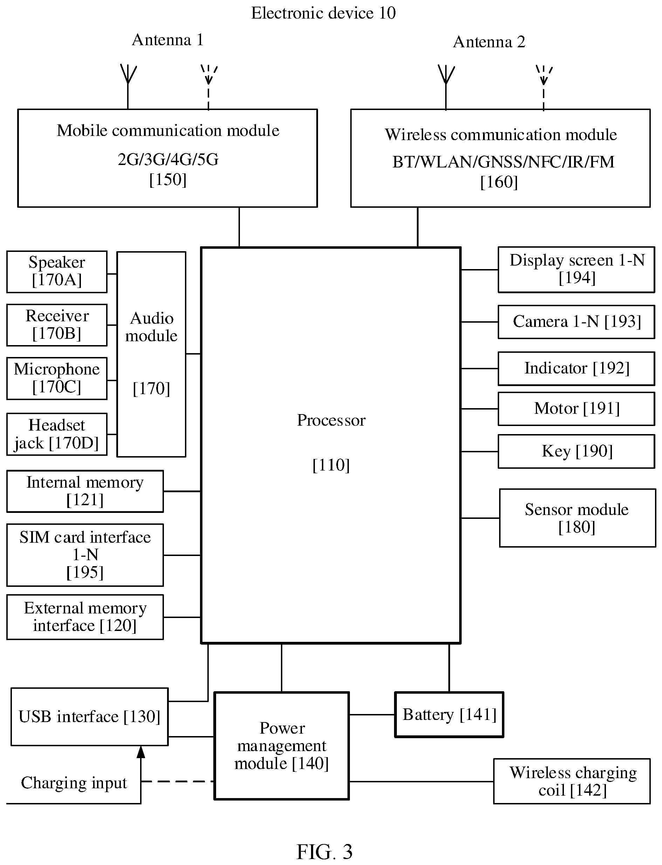

The electronic device 10 may be charged by a charger 20 shown in FIG. 1 or FIG. 2. The charger 20 may be a wired charger shown in FIG. 1, or a wireless charger shown in FIG. 2, or a charger in another form. When charging, the charger 20 shown in FIG. 1 is connected to the electronic device 10 in a wired manner, and the charger 20 shown in FIG. 2 is coupled to a wireless charging coil (refer to a wireless charging coil 142 in FIG. 3) in the electronic device 10 in a wireless manner (for example, through electromagnetic induction).

The method provided in this embodiment of this application is applicable to an electronic device including a plurality of batteries. The foregoing electronic device may include a mobile phone, a tablet computer, a notebook computer, a personal computer (personal computer, PC), an ultra-mobile personal computer (ultra-mobile personal computer, UMPC), a handheld computer, a netbook, a smart home device (such as a smart television, a smart screen, a large screen, a smart speaker, or a smart air conditioner), a personal digital assistant (personal digital assistant, PDA), a wearable device (such as a smart watch or a smart bracelet), an in-vehicle device, a virtual reality device, or the like. This is not limited in this embodiment of this application.

In this embodiment of this application, the electronic device may be an electronic device on which an operating system can run and an application can be installed. Optionally, the operating system that runs on the electronic device may be an Android^{®} system, a Windows^{®} system, an iOS^{®} system, or the like.

That the electronic device is a mobile phone is used as an example. FIG. 3 shows a possible structure of the electronic device. The electronic device 10 may include a processor 110, an external memory interface 120, an internal memory 121, a universal serial bus (universal serial bus, USB) interface 130, a power management module 140, a battery 141, a wireless charging coil 142, an antenna 1, an antenna 2, a mobile communication module 150, a wireless communication module 160, an audio module 170, a speaker 170A, a receiver 170B, a microphone 170C, a headset jack 170D, a sensor module 180, a key 190, a motor 191, an indicator 192, a camera 193, a display screen 194, and a subscriber identification module (subscriber identification module, SIM) card interface 195, and the like.

The sensor module 180 may include a pressure sensor, a gyro sensor, a barometric pressure sensor, a magnetic sensor, an acceleration sensor, a distance sensor, an optical proximity sensor, a fingerprint sensor, a temperature sensor, and a touch sensor, an ambient light sensor, a bone conduction sensor, and the like.

It may be understood that the structure illustrated in this embodiment of this application does not constitute a specific limitation on the electronic device 10. In some other implementations of this application, the electronic device 10 may include more or fewer components than those shown in the figure, or some components are combined, or some components are disassembled, or a different component arrangement is used. The components shown in the figure may be implemented by hardware, software, or a combination of software and hardware.

The processor 110 may include one or more processing units. For example, the processor 110 may include a central processing unit (central processing unit, CPU), an application processor (application processor, AP), a modem processor, a graphics processing unit (graphics processing unit, GPU), an image signal processor (image signal processor, ISP), a controller, a memory, a video codec, a digital signal processor (digital signal processor, DSP), a baseband processor, a neural-network processing unit (neural-network processing unit, NPU), and the like. Different processing units may be separate devices, or may be integrated into one or more processors. For example, the processor 110 may be an application processor AP. Alternatively, the processor 110 may be integrated in a system on chip (system on chip, SoC). Alternatively, the processor 110 may be integrated in an integrated circuit (integrated circuit, IC) chip. The processor 110 may include an analog front end (analog front end, AFE) and a micro-processing unit (microcontroller unit, MCU) in the IC chip.

The controller may be a nerve center and a command center of the electronic device 10. The controller may generate an operation control signal according to instruction operation code and a time-sequence signal, and control obtaining and execution of instructions.

A memory may also be disposed in the processor 110, configured to store instructions and data. In some implementations, the memory in the processor 110 is a cache. The memory may store an instruction or data recently used or cyclically used by the processor 110. If the processor 110 needs to use the instruction or the data again, the processor may directly call the instruction or the data from the memory, Repeated access is avoided, and waiting time of the processor 110 is reduced, thereby improving system efficiency.

In some implementations, the processor 110 may include one or more interfaces. The interface may include an inter-integrated circuit (inter-integrated circuit, I2C) interface, an inter-integrated circuit sound (inter-integrated circuit sound, I2S) interface, a pulse code modulation (pulse code modulation, PCM) interface, a universal asynchronous receiver/transmitter (universal asynchronous receiver/transmitter, UART) interface, a mobile industry processor interface (mobile industry processor interface, MIPI), a general-purpose input/output (general-purpose input/output, GPIO) interface, a subscriber identity module (subscriber identity module, SIM) interface, and/or a USB interface.

It may be understood that a schematic interface connection relationship between the modules in the embodiments of this application is merely an example for description, and constitutes no limitation on the structure of the electronic device 10. In some other implementations of this application, the electronic device 10 may alternatively use an interface connection manner different from that in the foregoing implementation, or use a combination of a plurality of interface connection manners.

A wireless communication function of the electronic device 10 may be implemented by using the antenna 1, the antenna 2, the mobile communication module 150, the wireless communication module 160, the modem processor, the baseband processor, and the like.

The antenna 1 and the antenna 2 are configured to transmit and receive an electromagnetic wave signal. Each antenna in the electronic device 10 may be configured to cover one or more communication frequency bands. Different antennas may further be multiplexed to improve utilization of the antennas. For example, the antenna 1 may be multiplexed as a diversity antenna of a wireless local area network. In some other implementations, the antenna may be used in combination with a tuning switch.

The mobile communication module 150 may provide a solution for wireless communication including 2G/3G/4G/5G and the like to be applied to the electronic device 10. The wireless communication module 160 may provide a solution for wireless communication solution including a wireless local area network (wireless local area networks, WLAN) (for example, a wireless fidelity (wireless fidelity, Wi-Fi) network), Bluetooth (bluetooth, BT), a global navigation satellite system (global navigation satellite system, GNSS), frequency modulation (frequency modulation, FM), a near field communication (near field communication, NFC) technology, an infrared (infrared, IR) technology, and the like to be applied to the electronic device 10. In some implementations, the antenna 1 and the mobile communication module 150 of the electronic device 10 are coupled, and the antenna 2 and the wireless communication module 160 are coupled, so that the electronic device 10 can communicate with a network and another device by using a wireless communication technology.

The electronic device 10 implements a display function by using the GPU, the display screen 194, the application processor, and the like. The GPU is a microprocessor for image processing and connects the display screen 194 and the application processor. The GPU is configured to perform mathematical and geometric calculations, for graphics rendering. The processor 110 may include one or more GPUs that execute a program instruction to generate or change display information.

The display screen 194 is configured to display an image, a video, and the like. The display screen 194 includes a display panel. In some implementations, the electronic device 10 may include 1 or N display screens 194. N is a positive integer greater than 1.

The electronic device 10 can implement a photographing function by using the ISP, the camera 193, the video codec, the GPU, the display screen 194, the application processor, and the like. The ISP is configured to process data fed back by the camera 193. In some implementations, the ISP may be disposed in the camera 193. The camera 193 is configured to capture a still image or video. In some implementations, the electronic device 10 may include 1 or N cameras 193. N is a positive integer greater than 1.

The external memory interface 120 may be configured to connect to an external memory card such as a micro SD card, to expand a storage capability of the electronic device 10. The external memory card communicates with the processor 110 through the external memory interface 120, to implement a data storage function, for example, store files such as music and a video into the external memory card.

The internal memory 121 may be configured to store computer-executable program code. The executable program code includes instructions. The processor 110 runs the instructions stored in the internal memory 121, to implement various functional applications and data processing of the electronic device 10. In addition, the internal memory 121 may include a highspeed random access memory, and may further include a non-volatile memory, for example, at least one magnetic disk storage device, a flash memory device, or a universal flash storage (universal flash storage, UFS).

The electronic device 10 may use the audio module 170, the speaker 170A, the receiver 170B, the microphone 170C, the headset jack 170D, the application processor, and the like, to implement an audio function, for example, music playback or recording.

The audio module 170 is configured to convert digital audio information into an analog audio signal output, and is also configured to convert an analog audio input into a digital audio signal. In some implementations, the audio module 170 may be disposed in the processor 110, or some functional modules of the audio module 170 are disposed in the processor 110. The speaker 170A, also referred to as a "horn", is configured to convert an electrical audio signal into a sound signal. The receiver 170B, also referred to as a "handset", is configured to convert an electrical audio signal into a sound signal. The microphone 170C, also referred to as a "voice tube" or "mike", is configured to convert a sound signal into an electrical signal. At least one microphone 170C may be disposed in the electronic device 10. The headset jack 170D is configured to be connected to a wired headset. The headset jack 170D may be a USB interface 130, or may be a 3.5 mm open mobile terminal platform (open mobile terminal platform, OMTP) standard interface, or a cellular telecommunications industry association of the USA (cellular telecommunications industry association of the USA, CTIA) standard interface.

The key 190 includes a power key, a volume key, or the like. The key 190 may be a mechanical key, or a touch-type key. The electronic device 10 may receive a key input, and generate a key signal input related to a user setting and function control of the electronic device 10. The motor 191 may generate a vibration alert. The motor 191 may be used for an incoming call vibration alert or a touch vibration feedback. The indicator 192 may be an indicator light, and may be configured to indicate a charging status and a battery change, and may also be configured to indicate a message, a missed call, a notification, and the like. The SIM card interface 195 is configured to be connected to a SIM card. The SIM card may be inserted into the SIM card interface 195 or unplugged from the SIM card interface 195, to come into contact with or be separated from the electronic device 10. The electronic device 10 can support one or N SIM card interfaces, where N is a positive integer greater than 1. The SIM card interface 195 can support a Nano SIM (Nano SIM) card, a Micro SIM (Micro SIM) card, a SIM card, and the like. In some implementations, the electronic device 10 uses an embedded SIM (embedded SIM, eSIM) card. The eSIM card may be embedded in the electronic device 10 and cannot be separated from the electronic device 10.

The power management module 140 is configured to receive a charging input from a charger. The charger may be a wireless charger (for example, a wireless charging dock of the electronic device 10 or another device that can charge the electronic device 10 wirelessly), or may be a wired charger. For example, the power management module 140 may receive a charging input from the wired charger through the USB interface 130. The power management module 140 may receive a wireless charging input through the wireless charging coil 142 of the electronic device 10.

The power management module 140 may also supply power to the electronic device 10 while charging the battery 141. The power management module 140 receives an input from the battery 141, and supplies power to the processor 110, the internal memory 121, the external memory interface 120, the display screen 194, the camera 193, the wireless communication module 160, and the like. The power management module 140 may be further configured to monitor parameters such as a battery capacity, a battery cycle count, and a battery health status (an electric leakage and impedance) of the battery 141. In some other implementations, the power management module 140 may alternatively be disposed in the processor 110.

The battery 141 may include a plurality of batteries with different capacities. Currently, when an electronic device includes a plurality of batteries, the plurality of batteries are usually connected in series for charging, or the plurality of batteries are connected in parallel for charging. In a charging process, an amount of electricity input to the battery is Q = I × t, where I is a charging current, and t is charging duration. That the plurality of batteries are connected in series or connected in parallel for charging at the same time means that the batteries have equal charging duration. A charging current of the battery is in direct proportion to the amount of electricity input to the battery.

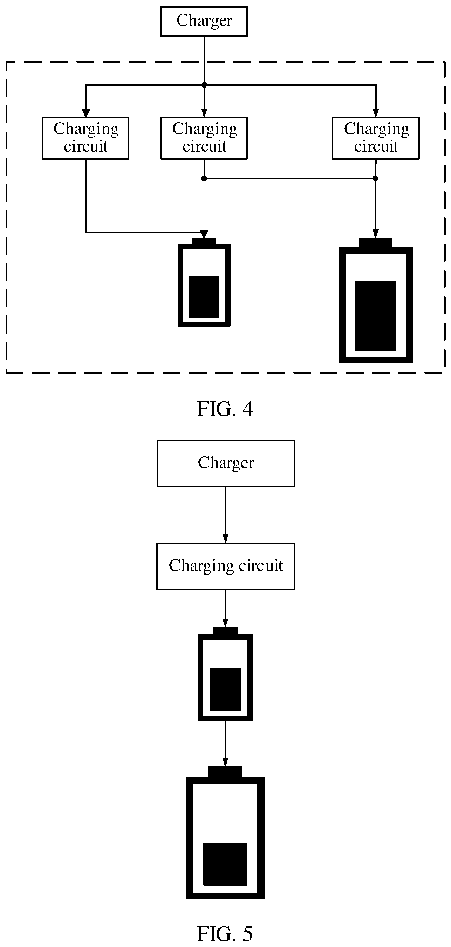

In an example, as shown in FIG. 4, two batteries are connected in parallel, and one charging circuit or a plurality of charging circuits that are connected in parallel charges or jointly charge the two batteries at the same time. Because the two batteries are connected in parallel, voltages of the two batteries are equal. However, an input current of a battery is affected by a resistance on a link (including a resistance of the battery, a line resistance, or the like). Consequently, respective input currents of the two batteries cannot be precisely controlled.

Because an input current of a battery cannot be precisely controlled, generally, a maximum input current of the battery is designed relatively high to avoid damage to the battery. The maximum input current of the battery is inversely proportional to a capacity density of the battery, resulting in a low capacity density of the battery. In a case of a same target capacity, a lower capacity density indicates a larger size of the battery. Due to the limited space within the electronic device, the size of the battery is limited and this results in a loss of the battery capacity.

In an example, as shown in FIG. 5, two batteries are connected in series, and a charging circuit charges the two batteries at the same time. In this implementation, input currents of the two batteries are equal, and amounts of electricity input to the two batteries within a same period of time are equal. When a battery with a smaller capacity is fully charged, a battery with a larger capacity is not fully charged. In addition, when the battery with the smaller capacity is fully charged, the charging is stopped to avoid damage to the battery. In this case, the battery with the larger capacity cannot be fully charged and the capacity is wasted.

The embodiments of this application provide a charging circuit and method, applied to charging of batteries with different capacities. The charging circuit may be applied to the power management module 140 of the electronic device 10.

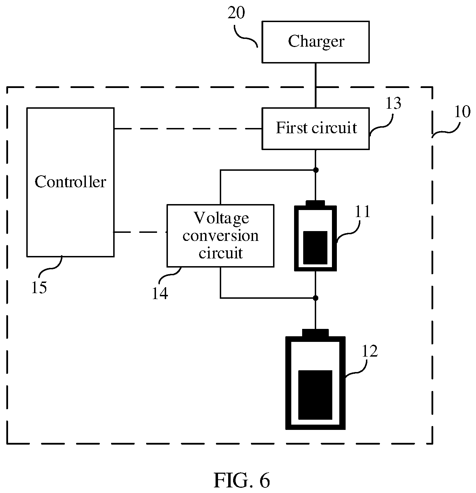

For example, as shown in FIG. 6, the electronic device 10 includes a first circuit 13, a voltage conversion circuit (a second circuit) 14, a controller 15, and a battery pack. The first circuit 13 and the voltage conversion circuit 14 serve as charging circuits to charge the battery pack. The battery pack includes a battery 11 and a battery 12, and capacities of the battery 11 and the battery 12 are different. For example, a capacity of the battery 11 is a first value, a capacity of the battery 12 is a second value, and the second value is greater than the first value. The first circuit 13 has one end coupled to a power supply terminal of a charger 20 and another end coupled to a positive electrode of the battery 11. A negative electrode of the battery 11 is coupled to a positive electrode of the battery 12. The voltage conversion circuit 14 has one end coupled to the positive electrode of the battery 11 and another end coupled to the negative electrode of the battery 11. A communication end of the first circuit 13 and a communication end of the voltage conversion circuit 14 are each in communication connection with the controller 15. For example, the first circuit 13 and the voltage conversion circuit 14 are connected to the controller 15 through an integrated circuit bus.

The first circuit 13 is configured to convert a supply voltage of the charger 20. An output voltage of the first circuit 13 is Vₒᵤₜ₁. The voltage conversion circuit 14 is configured to perform voltage conversion on Vₒᵤₜ₁. The controller 15 is configured to control a charging current I_{bat1} of the battery 11 by controlling a value of the output voltage Vₒᵤₜ₁ of the first circuit 13. The controller 15 is further configured to control an output current Iₒᵤₜ of the voltage conversion circuit 14 at Vₒᵤₜ₁, so that I_{bat1}/I_{bat2} = First value/Second value, where I_{bat2} = I_{bat1} + Iₒᵤₜ, that is, I_{bat1}/(I_{bat1} + Iₒᵤₜ) = First value/Second value. In other words, a ratio of the charging current input to the battery 11 to a charging current input to the battery 12 is equal to a ratio of the first value to the second value. It should be noted that during actual implementation, due to limitations such as detection accuracy and control accuracy, the ratio of the charging current input to the battery 11 to the charging current input to the battery 12 is not necessarily exactly equal to the ratio of the first value to the second value. The charging current input to the battery 11 and the charging current input to the battery 12 may be adjusted, so that their ratio tends to be equal to the ratio of the first value to the second value, that is, approximate to the ratio of the first value to the second value.

Because I_{bat1}/I_{bat2} = First value/Second value, within the same charging duration, a ratio of an amount of electricity input to the battery 11 to an amount of electricity input to the battery 12 equals First value/Second value = Capacity of battery 11/Capacity of battery 12. In this way, the battery 11 and the battery 12 can be fully charged at the same time, thereby avoiding a loss of battery capacities.

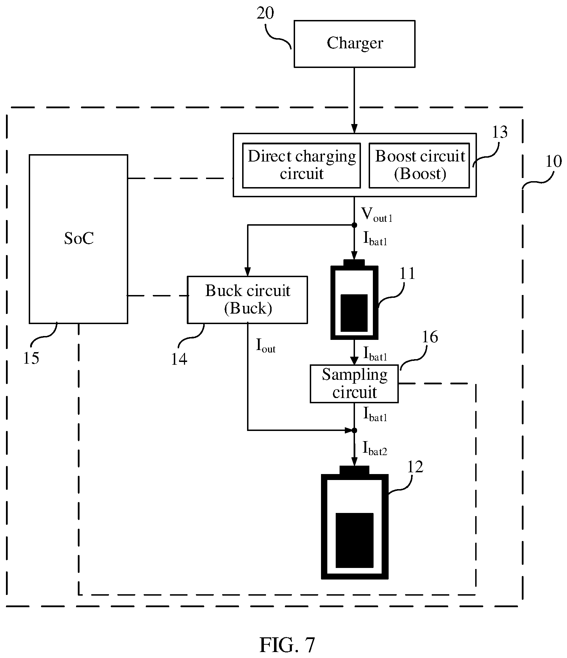

In an example, as shown in FIG. 7, the first circuit 13 is a direct charging circuit or a boost circuit (Boost). For example, the direct charging circuit is a switch circuit, and the Boost circuit may also be referred to as a Boost chip. Alternatively, the first circuit 13 may include a direct charging circuit and a Boost. The controller 15 may control, based on a supply voltage of the charger 20, the first circuit 13 to use the direct charging circuit or the Boost for charging. For example, when the supply voltage of the charger 20 is equal to a sum of rated voltages of the battery 11 and the battery 12, the controller 15 controls the first circuit 13 to use the direct charging circuit for charging. For example, when the supply voltage of the charger 20 is less than the sum of the rated voltages of the battery 11 and the battery 12, the controller 15 controls the first circuit 13 to use the Boost for charging. The voltage conversion circuit 14 is a buck circuit (Buck), or may also be referred to as a Buck chip. The controller 15 is a SoC. Optionally, the electronic device 10 further includes a sampling circuit 16. In an example, the sampling circuit 16 has one end coupled to the negative electrode of the battery 11 and another end coupled to the Buck 14. A communication end of the sampling circuit 16 is in communication connection with the controller 15. The sampling circuit 16 is configured to collect a value of the charging current I_{bat1} of the battery 11 in real time and report the value to the SoC. It should be noted that a resistance value of the sampling circuit 16 is very small, and a voltage difference between two ends of the sampling circuit 16 may be ignored.

The SoC is configured to determine target values of I_{bat1} and I_{bat2} based on the capacity of the battery 11 and the capacity of the battery 12, and send a control signal to the first circuit 13 and the Buck 14 separately. For example, the SoC sends a control signal to the first circuit 13 and the Buck 14 separately through an integrated circuit bus (inter-integrated circuit, IIC) communication protocol. For example, the SoC sends a first control signal to the first circuit 13, to notify a charging current target value (that is, a target value of I_{bat1}) of the battery 11. The SoC sends a second control signal to the Buck 14, to a notify an output current target value (that is, a target value of Iₒᵤₜ) of the Buck 14. Iₒᵤₜ = I_{bat2} - I_{bat1}.

The first circuit 13 is configured to perform voltage conversion on a supply voltage of the charger 20. An output voltage of the first circuit 13 is Vₒᵤₜ₁. In an implementation, the first circuit 13 adjusts a value of Vₒᵤₜ₁ based on a current value of I_{bat1} collected by the sampling circuit 16 in real time, so that the value of I_{bat1} is equal to the target value.

The Buck 14 is configured to perform voltage conversion on Vₒᵤₜ₁, and the value of the output current Iₒᵤₜ remains to be the target value of Iₒᵤₜ. Target value of Iₒᵤₜ = Target value of I_{bat2} - Target value of I_{bat1}.

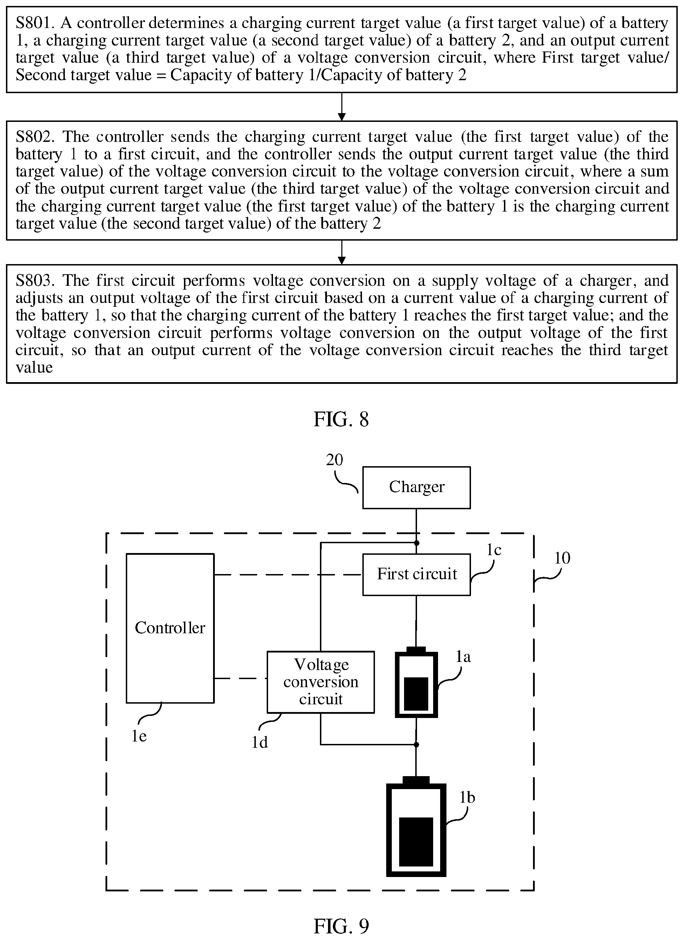

The charging method provided in the embodiments of this application is described in detail below. The method may be applied to the charging circuit shown in FIG. 6 or FIG. 7. For example, as shown in FIG. 8, the method includes the following steps.

S801. A controller determines a charging current target value (a first target value) of a battery 1, a charging current target value (a second target value) of a battery 2, and an output current target value (a third target value) of a voltage conversion circuit, where First target value/Second target value = Capacity of battery 1/Capacity of battery 2.

For example, the battery 1 is the battery 11, and the battery 2 is the battery 12. The capacity of the battery 1 is a first value, and the capacity of the battery 2 is a second value. The first value is less than the second value.

After an electronic device is connected to a charger in a wired or wireless manner, the electronic device charges the battery 1 and the battery 2 by using the charger. A charging current of a battery during charging undergoes a dynamic process. In an implementation, a charging process of a battery includes three stages: a precharge stage, a constant current charging stage, and a constant voltage charging stage. When an initial voltage/a no-load voltage of the battery is lower than a precharge threshold (for example, 3.0 V), the battery is at the precharge stage. A charging current of a single battery is approximately 10% of a charging current of the constant current charging stage. At the constant current charging stage, the charging current is constant (the charging current at this time is the maximum charging current), the voltage rises gradually, and this is a fast charging stage. For a single battery, the battery enters the constant voltage charging stage when reaching a particular voltage value. For example, the constant voltage value is 4.2 V. At the constant voltage charging stage, the voltage does not change, and the charging current gradually decreases. When the charging current reaches a termination current (for example, 0.01 C), the charging ends. Once the charging ends, the charging current drops to zero. The controller determines a current charging current target value of the battery 2 based on specific stages of the battery 1 and the battery 2 in the charging process.

For example, the battery 1 and the battery 2 are at the constant current charging stage, and it is determined that the current charging current target value of the battery 2 is a maximum charging current of the battery 2. It may be understood that the maximum charging current of the battery 2 is less than or equal to a maximum output current of the charger. In an example, the maximum charging current of the battery 2 is 3 A. In this case, it is determined that the charging current target value of the battery 2 is 3 A.

The charging current target value of the battery 1 is determined based on Charging current target value of battery 1/Charging current target value of battery 2 = Capacity of battery 1/Capacity of battery 2 = First value/Second value. For example, the first value is 2000 mA·h, the second value is 3000 mA·h, the target value of the charging current (I_{bat2}) of the battery 2 is 3 A, and the target value of the charging current (I_{bat1}) of the battery 1 is 2 A. Target value of output current (Iₒᵤₜ) of voltage conversion circuit = Target value of I_{bat2} - Target value of I_{bat1} . For example, Target value of Iₒᵤₜ = 3 A - 2 A = 1 A. That is, the first target value is 2 A, the second target value is 3 A, and the third target value is 1 A.

It should be noted that, in the foregoing example, the constant current charging stage is used as an example to describe the specific method for determining the charging current target value of the battery 1 and the charging current target value of the battery 2. It may be understood that, the charging current in the charging process undergoes a dynamic process, and at each stage of the charging process, the method can be used to determine the charging current target value of the battery 1 and the charging current target value of the battery 2, so that Charging current target value of battery 1/Charging current target value of battery 2 = Capacity of battery 1/Capacity of battery 2 = First value/Second value, and a current requirement of a corresponding stage is met (for example, a charging current of a single battery of the precharge stage is 10% of the charging current of the constant current charging stage).

S802. The controller sends the charging current target value (the first target value) of the battery 1 to a first circuit, and the controller sends the output current target value (the third target value) of the voltage conversion circuit to the voltage conversion circuit, where a sum of the output current target value (the third target value) of the voltage conversion circuit and the charging current target value (the first target value) of the battery 1 is the charging current target value (the second target value) of the battery 2.

In an implementation, the controller sends a first control signal to the first circuit through an IIC communication protocol, where the signal includes the first target value. The controller send a second control signal to the voltage conversion circuit through the IIC communication protocol, where the signal includes the third target value.

S803. The first circuit performs voltage conversion on a supply voltage of a charger, and adjusts an output voltage of the first circuit based on a current value of a charging current of the battery 1, so that the charging current of the battery 1 reaches the first target value. The voltage conversion circuit performs voltage conversion on the output voltage of the first circuit, so that an output current of the voltage conversion circuit reaches the third target value.

In an implementation, the first circuit is a direct charging circuit, such as a switch circuit.

In an example, a sampling circuit collects a value of I_{bat1} in real time and reports the value to the controller. The controller sends a current value of I_{bat1} to the direct charging circuit through an IIC communication protocol. If the current value of I_{bat1} is less than the first target value, the direct charging circuit negotiates with the charger through a charging protocol to increase the supply voltage of the charger by a first step (such as 0.5 V). In this way, an output voltage Vₒᵤₜ₁ of the direct charging circuit rises, that is, the value of I_{bat1} increases. If the current value of I_{bat1} is greater than the first target value, the direct charging circuit negotiates with the charger through a charging protocol to reduce the supply voltage of the charger by a second step (which may be or may not be equal to the first step, such as 0.5 V). In this way, the output voltage Vₒᵤₜ₁ of the direct charging circuit drops, that is, the value of I_{bat1} decreases. Through one or more adjustments, the value of I_{bat1} is caused to reach the first target value by raising or lowering the supply voltage of the charger.

In another example, a sampling circuit collects a value of I_{bat1} in real time and reports the value to the controller. If a current value of I_{bat1} is less than the first target value, the controller sends a boost signal to the direct charging circuit. The direct charging circuit negotiates with the charger through a charging protocol to increase the supply voltage of the charger by a first step (such as 0.5 V). In this way, an output voltage Vₒᵤₜ₁ of the direct charging circuit rises, that is, the value of I_{bat1} increases. If a current value of I_{bat1} is greater the first target value, the controller sends a buck signal to the direct charging circuit. The direct charging circuit negotiates with the charger through a charging protocol to lower the supply voltage of the charger by a second step (which may be or may not be equal to the first step, such as 0.5 V). In this way, the output voltage Vₒᵤₜ₁ of the direct charging circuit drops, that is, the value of I_{bat1} decreases. Through one or more adjustments, the value of I_{bat1} is caused to reach the first target value by raising or lowering the supply voltage of the charger.

In an implementation, the first circuit is a Boost. The Boost performs boost conversion on the supply voltage of the charger. In an example, a sampling circuit collects a value of I_{bat1} in real time and reports the value to the controller. The controller sends a current value of I_{bat1} to the Boost through an IIC communication protocol. If the current value of I_{bat1} is less than the first target value, the Boost increases the output voltage Vₒᵤₜ₁ by a first step (such as 0.5 V), that is, a value of I_{bat1} increases. If the current value of I_{bat1} is greater than the first target value, the Boost reduces the output voltage Vₒᵤₜ₁ by a second step (which may be or may not be equal to the first step, such as 0.5 V), that is, the value of I_{bat1} decreases. Through one or more adjustments, the value of I_{bat1} is caused to reach the first target value by raising or lowering the output voltage of the Boost. The Boost adjusts a duty cycle through pulse width modulation (pulse width modulation, PWM), performs boost conversion on the input voltage, and outputs a target voltage value. A person skilled in the art may implement a Boost function by using a conventional method that can be obtained. This is not limited in this embodiment of this application.

In an implementation, the voltage conversion circuit is a Buck. The Buck performs buck conversion on the output voltage of the first circuit, and the output current is the third target value. The Buck adjusts a duty cycle through pulse width modulation (pulse width modulation, PWM), performs buck conversion on the input voltage, outputs a target voltage value, and controls the output current to the target value through a feedback current. A person skilled in the art may implement a Buck function by using a conventional method that can be obtained. This is not limited in this embodiment of this application.

In the charging method provided in the embodiments of this application, the first circuit and the voltage conversion circuit jointly charge the battery 1 and the battery 2, and at each stage of the charging process, Charging current value of battery 1/Charging current value of battery 2 = Capacity of battery 1/Capacity of battery 2. In this way, the battery 1 and the battery 2 can be fully charged at the same time, thereby avoiding a loss of battery capacities.

It should be noted that in some embodiments, alternatively, the controller may not be used to determine the charging current target value (the first target value) of the battery 1, the charging current target value (the second target value) of the battery 2, and the output current target value (the third target value) of the voltage conversion circuit. Instead, the charging current target value of the battery 1 is directly preset in the first circuit, and the first circuit adjusts the output current based on the charging current target value of the battery 1; and the output current target value of the voltage conversion circuit is preset in the voltage conversion circuit, and the voltage conversion circuit adjusts the output current based on the output current target value. For a specific method of adjusting the output current based on the charging current target value of the battery 1 by the first circuit, and a specific method of adjusting the output current based on the output current target value by the voltage conversion circuit, refer to the detailed description in the foregoing embodiment. Details are not described herein again.

The embodiments of this application further provide a charging circuit and method, applied to charging of batteries with different capacities. The charging circuit may be applied to the power management module 140 of the electronic device 10.

For example, FIG. 9 shows another charging circuit provided in the embodiments of this application. The electronic device 10 includes a first circuit 1c, a voltage conversion circuit 1d, a controller 1e, and a battery pack. The first circuit 1c and the voltage conversion circuit (second circuit) 1d serve as charging circuits to charge the battery pack. The battery pack includes a battery 1a and a battery 1b, and capacities of the battery 1a and the battery 1b are different. For example, a capacity of the battery 1a is a first value, a capacity of the battery 1b is a second value, and the second value is greater than the first value. In an example, the first circuit 1c may be the first circuit 13 in FIG. 6, the voltage conversion circuit 1d may be the voltage conversion circuit 14 in FIG. 6, the controller 1e may be the controller 15 in FIG. 6, and the battery 1a and the battery 1b are respectively the battery 11 and the battery 12 in FIG. 6. For connection manners and functions of the units in FIG. 9, refer to the corresponding units in FIG. 6. Different from the charging circuit shown in FIG. 6, in which the voltage conversion circuit 14 and the battery 11 are connected in parallel, in the charging circuit shown in FIG. 9, the voltage conversion circuit 1d has one end coupled to a power supply terminal of the charger 20 and another end coupled to a negative electrode of the battery 1a. That is, the voltage conversion circuit 1d is connected in parallel with a circuit obtained after the first circuit 1c is connected in series with the battery 1a. In other words, in FIG. 9, the voltage conversion circuit 1d does not perform voltage conversion on an output voltage Vₒᵤₜ₁ of the first circuit 1c, but performs voltage conversion on a supply voltage of the charger 20.

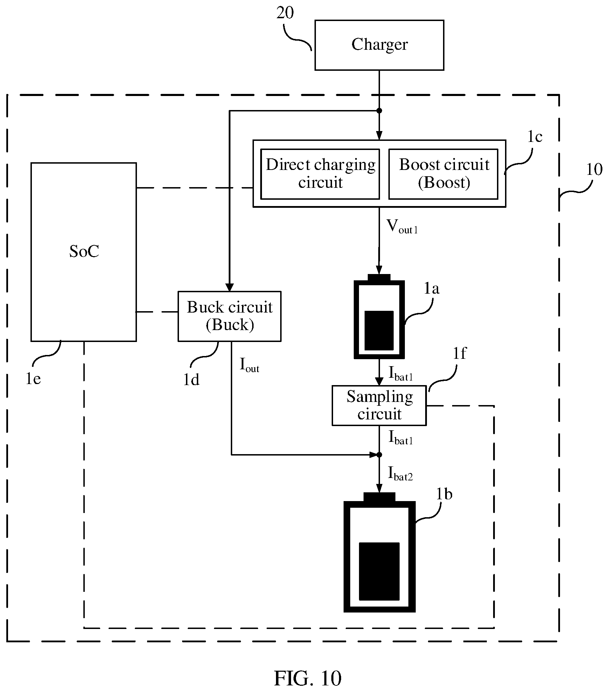

In an implementation, as shown in FIG. 10, the first circuit 1c may be a direct charging circuit or a boost circuit (Boost); or the first circuit 1c includes a direct charging circuit and a Boost. The voltage conversion circuit 1d is a buck circuit (Buck), or may also be referred to as a Buck chip. The controller 1e is a SoC. In an example, the charging circuit may further include a sampling circuit 1f. The sampling circuit 1f has one end coupled to the negative electrode of the battery 1a and another end coupled to the Buck 1d. A communication end of the sampling circuit 1f is in communication connection with the controller 1e.

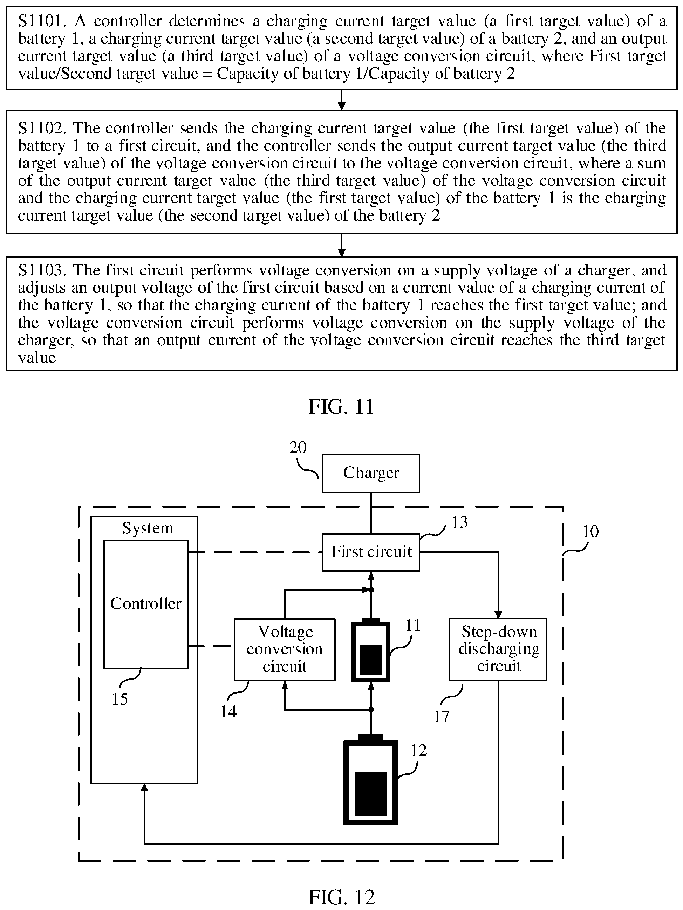

An embodiment of this application provides a charging method. The method may be applied to the charging circuit shown in FIG. 9 or FIG. 10. For example, as shown in FIG. 11, the method includes the following steps.

S1101. A controller determines a charging current target value (a first target value) of a battery 1, a charging current target value (a second target value) of a battery 2, and an output current target value (a third target value) of a voltage conversion circuit, where First target value/Second target value = Capacity of battery 1/Capacity of battery 2.

S1102. The controller sends the charging current target value (the first target value) of the battery 1 to a first circuit, and the controller sends the output current target value (the third target value) of the voltage conversion circuit to the voltage conversion circuit, where a sum of the output current target value (the third target value) of the voltage conversion circuit and the charging current target value (the first target value) of the battery 1 is the charging current target value (the second target value) of the battery 2.

For specific implementations of S1101 and S1102, refer to S801 and S802. Details are not described herein again.

S1103. The first circuit performs voltage conversion on a supply voltage of a charger, and adjusts an output voltage of the first circuit based on a current value of a charging current of the battery 1, so that the charging current of the battery 1 reaches the first target value. The voltage conversion circuit performs voltage conversion on the supply voltage of the charger, so that an output current of the voltage conversion circuit reaches the third target value.

For a specific implementation in which the first circuit performs voltage conversion on a supply voltage of a charger, and adjusts an output voltage of the first circuit based on a current value of a charging current of the battery 1, so that the charging current of the battery 1 reaches the first target value, refer to S803.

Different from S803, the voltage conversion circuit (such as a Buck) performs buck conversion on the supply voltage of the charger, and the output current is the third target value.

The first circuit and the voltage conversion circuit jointly charge the battery 1 and the battery 2, and at each stage of the charging process, Charging current value of battery 1/Charging current value of battery 2 = Capacity of battery 1/Capacity of battery 2. In this way, the battery 1 and the battery 2 can be fully charged at the same time, thereby avoiding a loss of battery capacities.

The battery 141 (for example, including the battery 11 and the battery 12, or including the battery 1a and the battery 1b) in FIG. 3 is configured to supply power to each unit (the system) in the electronic device 10. For example, the battery 141 may supply power to the processor 110, the internal memory 121, the external memory interface 120, the display screen 194, the camera 193, the wireless communication module 160, and the like, to support normal operation of the system of the electronic device 10.

That a battery supplies power to a system means that the battery discharges. Generally, a plurality of batteries are connected in series for charging, and are also connected in series for discharging. Because a rated supply voltage (which, for example, is equal to a supply voltage of a single battery) of the system is less than a supply voltage of a plurality of batteries connected in series, when the plurality of batteries are connected in series to supply power, step-down discharging is required.

In an example, as shown in FIG. 12, the battery 11 and the battery 12 are connected in series. A discharge current of the battery 11 is input to a step-down discharging circuit 17 through the first circuit 13. A discharge current of the battery 12 is reversely boosted by the voltage conversion circuit (Buck) and then input to the step-down discharging circuit 17 through the first circuit 13. The step-down discharging circuit 17 supplies power to the system after stepping down the input voltage. For example, the supply voltage of the single battery is 5 V, the supply voltage of the battery 11 and the battery 12 connected in series is 10 V, and the rated supply voltage of the system is 5 V. The step-down discharging circuit 17 is configured to implement buck conversion from 10 V (the supply voltage of the battery) to 5 V (the rated supply voltage of the system), that is, implement 2:1 power conversion. Only about 50% of output power of each of the battery 11 and the battery 12 is used to supply power to the system, resulting in a loss of efficiency and a waste of battery capacities.

An embodiment of this application further provides a circuit for automatic switching between charging and discharging. For example, the circuit for automatic switching between charging and discharging may be a power supply circuit in an electronic device. During charging of a battery pack, batteries are connected in series. a first circuit and a voltage conversion circuit jointly charge a battery 1 and a battery 2, so that Charging current value of battery 1/Charging current value of battery 2 = Capacity of battery 1/Capacity of battery 2, and the battery 1 and the battery 2 can be fully charged at the same time. When the battery pack supplies power to a system, the batteries are connected in parallel, and a supply voltage of the battery is equal to a rated supply voltage of the system, thereby avoiding an efficiency loss caused by power conversion by a discharging circuit and avoiding a waste of battery capacities.

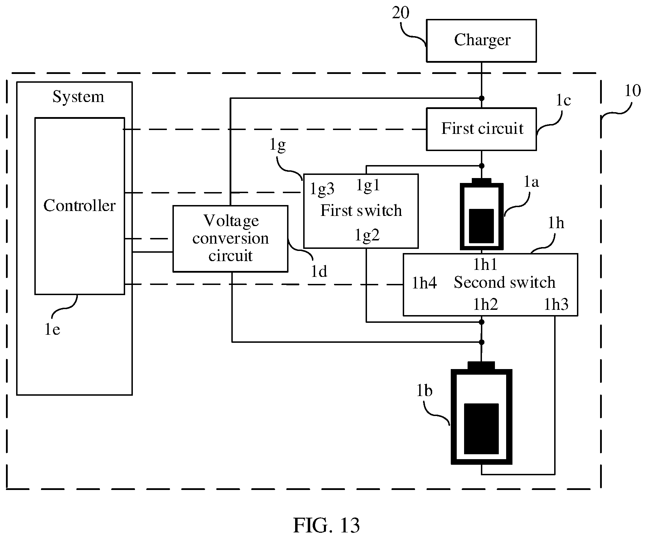

In an example, as shown in FIG. 13, the electronic device 10 includes a power supply circuit. The power supply circuit includes a battery 1a, a battery 1b, a first circuit 1c, a voltage conversion circuit 1d, a first switch 1g, and a second switch 1h. Capacities of the battery 1a and the battery 1b are different. For example, a capacity of the battery 1a is a first value, a capacity of the battery 1b is a second value, and the second value is greater than the first value. Optionally, the power supply circuit may further include a sampling circuit 1f (not shown in FIG. 13), and the like. The power supply circuit may interact with another unit in the electronic device 10. For example, the power supply circuit may perform wireless communication with the controller 1e and receive a control signal from the controller 1e. For example, the power supply circuit may supply power to a system of the electronic device 10.

The first circuit 1c has one end coupled to a power supply terminal of a charger 20 and another end coupled to a positive electrode of the battery 1a. A negative electrode of the battery 1a is coupled to a first controlled terminal 1h1 of the second switch 1h. A first controlled terminal 1g1 of the first switch 1g is coupled to the positive electrode of the battery 1a. A second controlled terminal 1g2 of the first switch 1g is coupled to a second controlled terminal 1h2 of the second switch 1h and a positive electrode of the battery 1b. A third controlled terminal 1h3 of the second switch 1h is coupled to a negative electrode of the battery 1b. The voltage conversion circuit 1d has one end coupled to the power supply terminal of the charger 20 and another end coupled to the positive electrode of the battery 1b. The power supply terminal is coupled to a power supply interface of the system. A communication end of the first circuit 1c, a communication end of the voltage conversion circuit 1d, a control terminal of the first switch 1g, and a control terminal of the second switch 1h are separately in communication connection with (for example, connected through an integrated circuit bus to) the controller 1e.

In an example, the first circuit 1c is a direct charging circuit, the voltage conversion circuit 1d is a Buck, and the controller 1e is a SoC. The controller 1e may send a signal to the communication end of the first circuit 1c to control the first circuit 1c (the direct charging circuit) to be on or off. The controller 1e may send a signal to the control terminal 1g3 of the first switch 1g to control the first controlled terminal 1g1 of the first switch 1g to be electrically connected to or disconnected from the second controlled terminal 1g2. The controller may further send a signal to the control terminal 1h4 of the second switch 1h to control the first controlled terminal 1h1 of the second switch 1h to be electrically connected to the second controlled terminal 1h2 and control the first controlled terminal 1h1 to be electrically disconnected from the third controlled terminal 1h3; or control the first controlled terminal 1h1 of the second switch 1h to be electrically disconnected from the second controlled terminal 1h2 and control the first controlled terminal 1h1 to be electrically connected to the third controlled terminal 1h3.

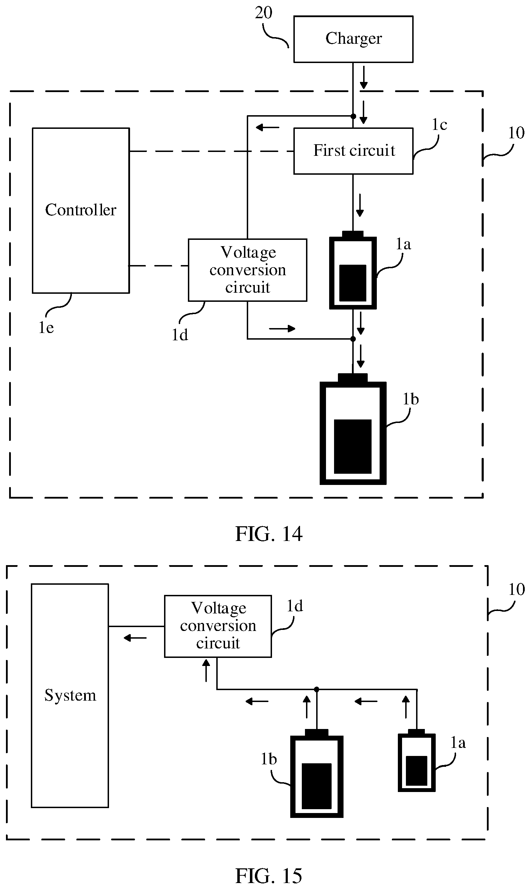

In an implementation, when the battery pack is to be charged, the controller 1e determines that it is currently a charging process; and the controller 1e controls the first circuit 1c to be on; controls the first switch 1g to be off; and controls the first controlled terminal 1h1 of the second switch 1h to be electrically connected to the second controlled terminal 1h2 and controls the first controlled terminal 1h1 to be electrically disconnected from the third controlled terminal 1h3. In this way, the battery 1a and the battery 1b are connected in series. An equivalent circuit diagram is shown in FIG. 9. For example, when the battery pack is to be charged, a current direction is shown in FIG. 14, and the first circuit 1c and the voltage conversion circuit 1d jointly charge the battery 1a and the battery 1b.

When the battery pack supplies power to the system, the controller 1e determines that it is currently a discharging process; and the controller 1e controls the first circuit 1c to be off; controls the first switch 1g to be on; and controls the first controlled terminal 1h1 of the second switch 1h to be electrically disconnected from the second controlled terminal 1h2 and controls the first controlled terminal 1h1 to be electrically connected to the third controlled terminal 1h3. An equivalent circuit diagram is shown in FIG. 15, and the battery 1a and the battery 1b are connected in parallel and supply power to the system through the voltage conversion circuit 1d.

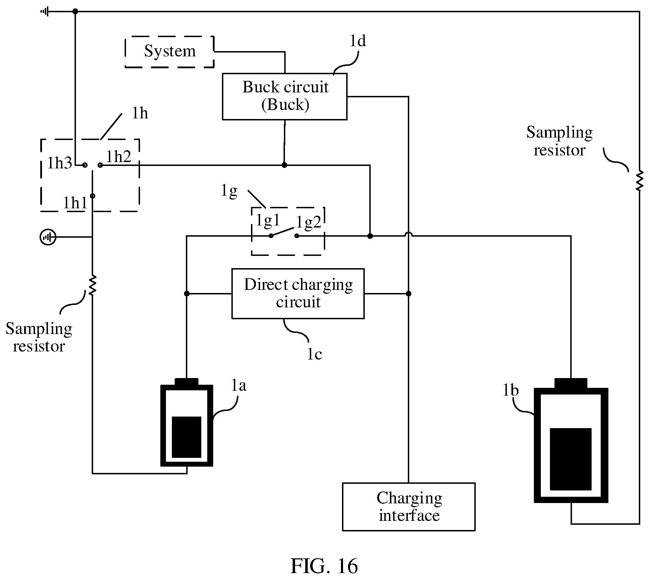

FIG. 16 is a schematic diagram of a circuit for automatic switching between charging and discharging according to an embodiment of this application. As shown in FIG. 16, the first circuit is a direct charging circuit, and the voltage conversion circuit is a Buck. The battery 1a and the battery 1b are each connected in series with a sampling resistor. It may be understood that, in some other examples, the circuit may alternatively not include any sampling resistor.

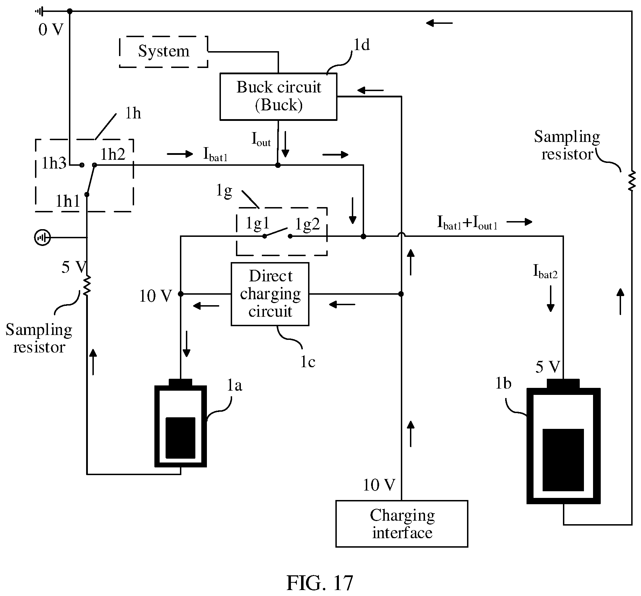

When the battery pack is to be charged, the direct charging circuit 1c is on, the first switch 1g is off, the first controlled terminal 1h1 of the second switch 1h is electrically connected to the second controlled terminal 1h2 and the first controlled terminal 1h1 is electrically disconnected from the third controlled terminal 1h3; and the battery 1a and the battery 1b are connected in series. A current direction is shown in FIG. 17. For example, an input voltage of a charging interface (the supply voltage of the charger) is 10 V, the output voltage Vₒᵤₜ₁ of the direct charging circuit 1c is 10 V, and a charging current flows through the battery 1a through the direct charging circuit 1c is I_{bat1}. The Buck performs buck conversion on the supply voltage of the charger, and the output voltage is 5 V, that is, a voltage of a negative electrode of the battery 1a is 5 V; and an output current of the Buck is Iₒᵤₜ. In this way, a charging current of the battery 1b is I_{bat1} + Iₒᵤₜ = I_{bat2}. A voltage of a positive electrode of the battery 1b is equal to the output voltage of the Buck, and is 5 V; and a negative electrode of the battery 1b is grounded, and the voltage is 0 V. In the connection manner of this circuit, the battery 1a and the battery 1b are connected in series, and the direct charging circuit 1c and the Buck 1d jointly charge the battery 1a and the battery 1b, so that Charging current value of battery 1a/Charging current value of battery 1b = Capacity of battery 1a/Capacity of battery 1b, and the battery 1a and the battery 1b can be fully charged at the same time.

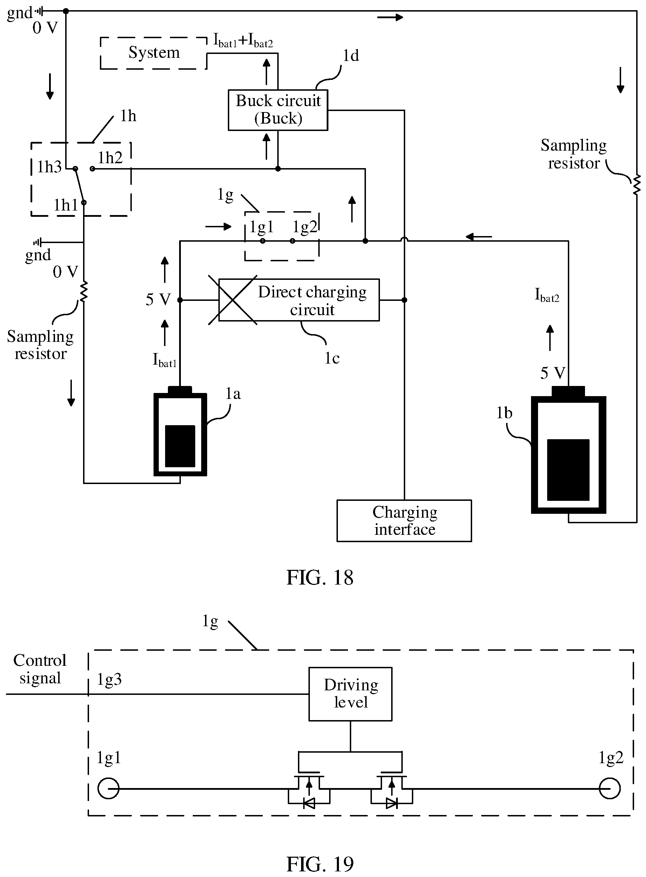

When the battery pack supplies power to the system, the direct charging circuit 1c is off, the first switch 1g is n, the first controlled terminal 1h1 of the second switch 1h is electrically disconnected from the second controlled terminal 1h2, and the first controlled terminal 1h1 is electrically connected to the third controlled terminal 1h3; and the battery 1a and the battery 1b are connected in parallel. A current direction is shown in FIG. 18, a voltage difference between positive and negative electrodes of a single battery is 5 V, that is, the voltage of the positive electrode of each of the battery 1a and the battery 1b is 5 V. An output current of the battery 1a is I_{bat1}, an output current of the battery 1b is I_{bat2}, and a current flowing through the Buck is I_{bat1}+I_{bat2}, that is, a power supply current of the battery 1a and the battery 1b supplying power to the system is I_{bat1}+I_{bat2}. An input voltage of the Buck is 5 V, an output voltage (a rated supply voltage of the system) is also 5 V, thereby avoiding an efficiency loss caused by power conversion and avoiding a waste of battery capacities.

In an example, FIG. 19 shows a specific implementation of the first switch. When the battery pack is charged, the SoC sends a high-level control signal to the first switch, a driving level outputs a high level, and a double N-type metal oxide semiconductor field effect transistor (metal oxide semiconductor field effect transistor, MOSFET, MOS transistor for short) on the top is on, that is, the first switch is on. When the battery pack supplies power to the system, the SoC sends a low-level control signal to the first switch, a driving level outputs a low level, and a double N-type MOS transistor on the top is off, that is, the first switch is off.

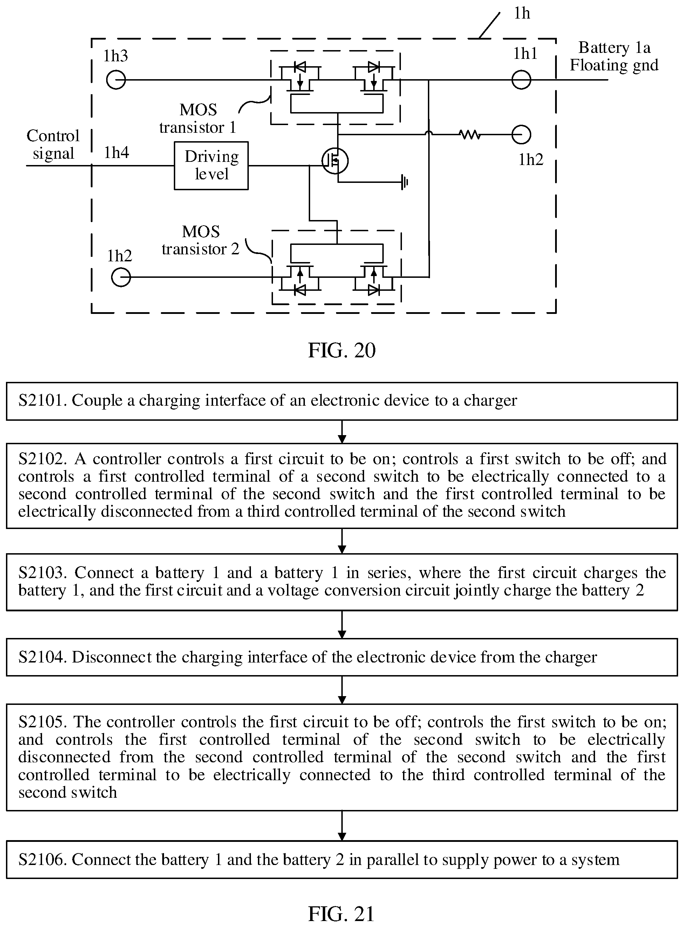

In an example, FIG. 20 shows a specific implementation of the second switch. When the battery pack is charged, the SoC sends a high-level control signal to the second switch, a driving level outputs a high level, a MOS transistor 1 is off, and a MOS transistor 2 is on; that is, the first controlled terminal 1h1 is electrically connected to the second controlled terminal 1h2, and the first controlled terminal 1h1 is electrically disconnected from the third controlled terminal 1h3. When the battery pack supplies power to the system, the SoC sends a low-level control signal to the second switch, a driving level outputs a low level, a MOS transistor 1 is on, and a MOS transistor 2 is off; that is, the first controlled terminal 1h1 is electrically disconnected from the second controlled terminal 1h2, and the first controlled terminal 1h1 is electrically connected to the third controlled terminal 1h3.

For example, in the processes in which the battery pack is charged and the battery pack supplies power to the system, voltage changes of all endpoints are shown in Table 1.

**Table 1**

| | MOS transistor 1 | MOS transistor 2 | Voltage of 1h1 | Voltage of 1h2 | Voltage of 1h3 | Voltage of 1h4 |
|---|---|---|---|---|---|---|
| Battery pack is charged | Off | On | 4 V | 4 V | 0 V | 4 V+Vgs |
| Battery pack supplies power to system | On | Off | 0 V | 4 V | 0 V | Off |

For example, FIG. 21 is a schematic flowchart of a method for automatic switching between a charging circuit and a discharging circuit. The method may be applied to the circuit shown in FIG. 13. As shown in FIG. 21, the method includes the following steps.

S2101. Couple a charging interface of an electronic device to a charger.

A battery pack of the electronic device includes a battery 1 and a battery 2, a capacity of the battery 1 is a first value, a capacity of the battery 2 is a second value, and the first value is less than the second value. For example, the battery 1 is the foregoing battery 1a, and the battery 2 is the foregoing battery 1b.

A controller determines that the charging interface of the electronic device is coupled to the charger, and enters a process of charging the battery pack.

S2102. A controller controls a first circuit to be on; controls a first switch to be off; and controls a first controlled terminal of a second switch to be electrically connected to a second controlled terminal of the second switch and the first controlled terminal to be electrically disconnected from a third controlled terminal of the second switch.

For example, the first circuit is a direct charging circuit, the first switch is shown in FIG. 19, and the second switch is shown in FIG. 20. The controller communicates with a communication end of the first circuit through an IIC communication protocol to control the first circuit to be on. The controller communicates with a control terminal of the first switch through the IIC communication protocol to control the first switch to be off. The controller communicates with a control terminal of the second switch through the IIC communication protocol to control the first controlled terminal of the second switch to be electrically connected to the second controlled terminal of the second switch and the first controlled terminal to be electrically disconnected from the third controlled terminal of the second switch. In this way, the battery 1 and the battery 2 are connected in series.

S2103. Connect a battery 1 and a battery 1 n series, where the first circuit charges the battery 1, and the first circuit and a voltage conversion circuit jointly charge the battery 2.

In an implementation, the battery 1 and the battery 2 may be charged by using the method shown in FIG. 11. For example, a current direction is shown in FIG. 17.

S2104. Disconnect the charging interface of the electronic device from the charger.

The controller determines that the charging interface of the electronic device is disconnected from the charger and determines that the battery pack supplies power to a system.

S2105. The controller controls the first circuit to be off; controls the first switch to be on; and controls the first controlled terminal of the second switch to be electrically disconnected from the second controlled terminal of the second switch and the first controlled terminal to be electrically connected to the third controlled terminal of the second switch.

For example, the first circuit is a direct charging circuit, the first switch is shown in FIG. 19, and the second switch is shown in FIG. 20. The controller communicates with the communication end of the first circuit through the IIC communication protocol to control the first circuit to be off. The controller communicates with the control terminal of the first switch through the IIC communication protocol to control the first switch to be on. The controller communicates with the control terminal of the second switch through the IIC communication protocol to control the first controlled terminal of the second switch to be electrically disconnected from the second controlled terminal of the second switch and the first controlled terminal to be electrically connected to the third controlled terminal of the second switch. In this way, the battery 1 and the battery 2 are connected in parallel.

S2106. Connect the battery 1 and the battery 2 in parallel to supply power to a system.

For example, a current direction is shown in FIG. 18.

In some embodiments, when the charging interface of the electronic device is coupled to the charger, a power supply current of the charger may be partially used for charging the battery pack of the electronic device charge, and partially used for supplying power to the system of the electronic device, to ensure normal operation of the electronic device.

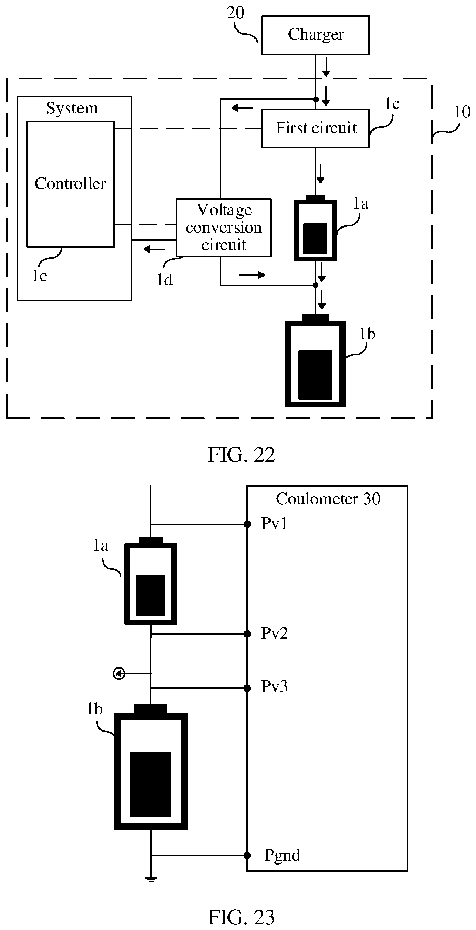

In an example, the charger 20 is electrically connected to the charging interface of the electronic device 10. The controller 1e determines that it is currently in a charging process, controls the first circuit 1c to be on, and controls the first switch 1g to be off; and controls the first controlled terminal 1h1 of the second switch 1h to be electrically connected to the second controlled terminal 1h2 and the first controlled terminal 1h1 to be electrically disconnected from the third controlled terminal 1h3. In this way, the battery 1a and the battery 1b are connected in series. For example, an equivalent circuit is shown in FIG. 22. The first circuit 1c performs voltage conversion on a supply voltage of the charger 20, and outputs a charging current I_{bat1} to the battery 1a. The voltage conversion circuit 1d performs voltage conversion on the supply voltage of the charger 20. One part of an output current Iₒᵤₜ and the charging current I_{bat1} of the battery 1a are jointly input to the battery 1b to charge the battery 1b. Another part of the output current supplies power to the system. In this embodiment, power is supplied to the system by the charger 20 through the Buck of the electronic device 10, rather than by the battery pack of the electronic device 10.

An embodiment of this application further provides a coulometer, which may be applied not only to a circuit in which a plurality of batteries are connected in series, but also to a circuit in which a plurality of batteries are connected in parallel. The coulometer may be a part of the electronic device 10, for example, the power management module 140 in FIG. 3, or may be an independent electronic device. This embodiment of this application and the accompanying drawings are illustrated by using an example in which the coulometer is a power management chip.

In some embodiments, as shown in FIG. 23, during charging of a battery 1a and a battery 1b, the battery 1a and the battery 1b are connected in series; and A negative electrode of the battery 1a is coupled to a positive electrode of the battery 1b, and a negative electrode of the battery 1b is grounded. When the battery 1a and the battery 1b supply power to the outside, the battery 1a and the battery 1b are connected in parallel; and the negative electrode of the battery 1a is grounded, and the negative electrode of the battery 1b is grounded. For example, the battery 1a and the battery 1b are connected in the circuit shown in FIG. 13. The coulometer 30 is configured to measure a voltage of the battery 1a and a voltage of the battery 1b. The coulometer 30 includes pins Pv1, Pv2, Pv3, and Pgnd. The pin Pv1 is coupled to a positive electrode of the battery 1a and is used to collect a voltage value of the positive electrode of the battery 1a. The pin Pv2 is coupled to the negative electrode of the battery 1a and is used to collect a voltage value of the negative electrode of the battery 1a. The pin Pv3 is coupled to the positive electrode of the battery 1b and is used to collect a voltage value of the positive electrode of the battery 1b. The pin Pgnd is grounded, that is, the pin Pgnd is coupled to the negative electrode of the battery 1b, and a voltage value is 0 V. The coulometer 30 may obtain a voltage of the battery 1a (that is, a voltage difference between the positive and negative electrodes of the battery 1a) through the pins Pv1 and Pv2, and may obtain a voltage of the battery 1b (that is, a voltage difference between the positive and negative electrodes of the battery 1b) through the pin Pv3.

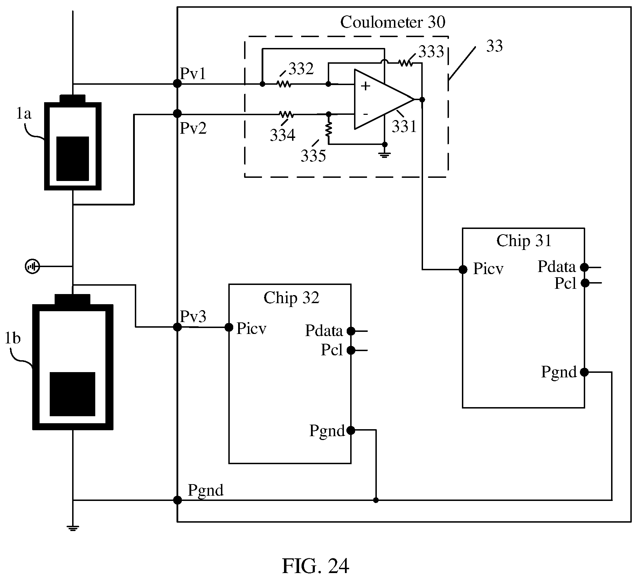

In an implementation, as shown in FIG. 24, the coulometer 30 includes a chip 31, a chip 32, and a differential amplifier (a differential amplifier circuit) 33. A positive input terminal of the differential amplifier 33 is connected to the pin Pv1. A negative input terminal of the differential amplifier 33 is connected to the pin Pv2. The differential amplifier 33 includes an operational amplifier 331, a resistor 332, a resistor 333, a resistor 334, and a resistor 335. The positive input terminal of the differential amplifier 33 is connected to one terminal of the resistor 332 and a power terminal of the operational amplifier 331. The other terminal of the resistor 332 is connected to a positive input terminal of the operational amplifier 331 and one terminal of the resistor 333. The other terminal of the resistor 333 is connected to an output terminal of the operational amplifier 331. The negative input terminal of the differential amplifier 33 is connected to one terminal of the resistor 334. The other terminal of the resistor 334 is connected to a negative input terminal of the operational amplifier 331 and one terminal of the resistor 335. The other terminal of the resistor 335 is connected to a ground terminal of the operational amplifier 331. Resistance values of the resistor 332, the resistor 333, the resistor 334, and the resistor 335 are equal. In this way, Value output by output terminal of differential amplifier 33 = Voltage value collected by pin Pv1 - Voltage value collected by pin Pv2 = Voltage of battery 1a. In an example, the chip 31 and the chip 32 are the same chip, for example, a power management chip (a coulometer). The chip 31 and the chip 32 each include a plurality of pins (or referred to as pins, and the like). For example, the chip 31 and the chip 32 each include a pin Picv. The pin Picv of the chip 31 is connected to the output terminal of the differential amplifier 33, and the chip 31 obtains the voltage of the battery 1a based on a voltage value collected by the pin Picv. In other words, Voltage value collected by pin Picv of chip 31 = Value output by output terminal of differential amplifier 33 = Voltage of battery 1a. The pin Picv of the chip 32 is connected to the pin Pv3 of the coulometer 30, and the chip 32 obtains the voltage of the battery 1b based on a voltage value collected by the pin Picv. That is, Voltage value collected by pin Picv of chip 32 = Voltage of battery 1b.

Optionally, the chip 31 and the chip 32 each further include a pin Pdata and a pin Pcl, used to communicate with another chip (such as a SoC) through an IIC communication protocol. Optionally, the coulometer 30 may further include a pin Pdata and a pin Pcl (not shown in the figure). The pin Pdata of each of the chip 31 and the chip 32 is connected to the pin Pdata of the coulometer 30. The pin Pcl of each of the chip 31 and the chip 32 is connected to the pin Pcl of the coulometer 30. The coulometer 30 has the pin Pdata and the pin Pcl connected to an integrated circuit bus of the electronic device 10, and reports the voltage of the battery 1a and the voltage of the battery 1b to the controller 15 through the IIC communication protocol.

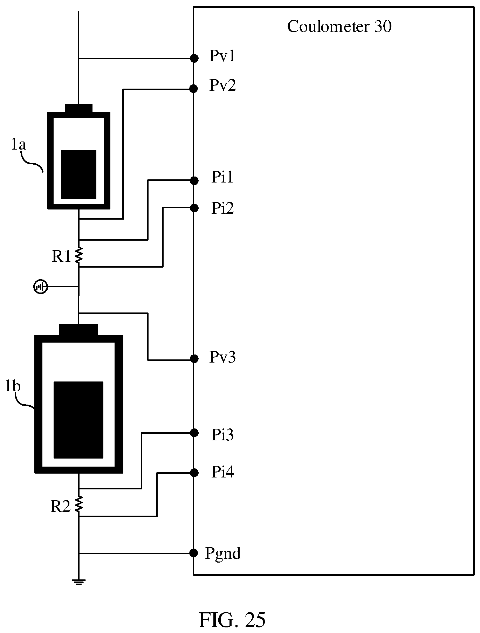

In some embodiments, the coulometer 30 is further configured to measure a current flowing through (input to or output from) the battery 1a and a current flowing through (input to or output from) the battery 1b. For example, as shown in FIG. 25, the battery 1a is connected in series with a sampling resistor R1, and the battery 1b is connected in series with a sampling resistor R2. It may be understood that resistance values of R1 and R2 are very small, and a voltage difference between two terminals of the sampling resistor may be ignored. The coulometer 30 further includes pins Pi1, Pi2, Pi3, and Pi4. The pins Pi1 and Pi2 are respectively coupled to the two terminals of the sampling resistor R1, for collecting a voltage value at the two terminals of R1. The pins Pi3 and Pi4 are respectively coupled to the two terminals of the sampling resistor R2, for collecting a voltage value at the two terminals of R2. The coulometer 30 may obtain a current flowing through R1 based on the voltage value at the two terminals of R1 and the resistance value of R1, that is, obtain the current flowing through the battery 1a; and may obtain a current flowing through R2 based on the voltage value at the two terminals of R2 and the resistance value of R2, that is, obtain the current flowing through the battery 1b. It should be noted that in the example in FIG. 25, the coulometer 30 does not include the sampling resistors R1 and R2. During actual application, the sampling resistors R1 and R2 may alternatively be disposed in the coulometer 30.

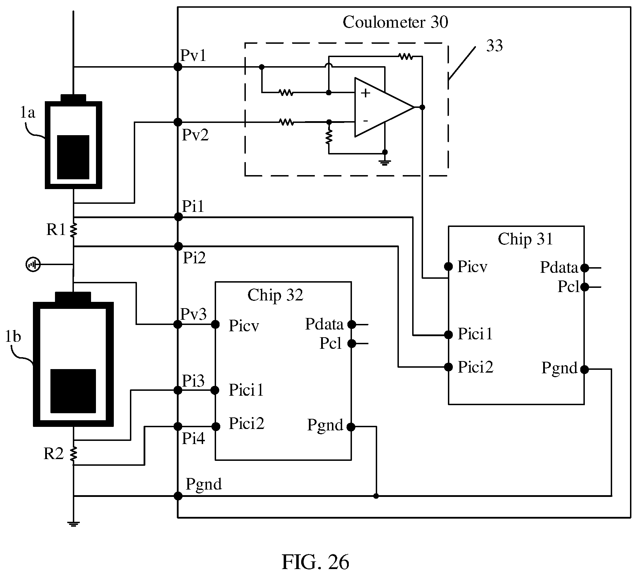

In an implementation, as shown in FIG. 26, the chip 31 and the chip 32 each include a pin Pici1 and a pin Pici2. The pins Pici1 and Pici2 of the chip 31 are respectively connected to the pins Pi1 and Pi2 of the coulometer 30. The chip 31 collects the voltage value at the two terminals of R1 through the pins Pici1 and Pici2, and obtains the current flowing through the battery 1a based on the voltage value at the two terminals of R1 and the resistance value of R1. The pins Pici1 and Pici2 of the chip 32 are respectively connected to the pins Pi3 and Pi4 of the coulometer 30. The chip 32 collects the voltage value at the two terminals of R2 through the pins Pici1 and Pici2, and obtains the current flowing through the battery 1b based on the voltage value at the two terminals of R2 and the resistance value of R2.

Optionally, in an example, the coulometer 30 has the pin Pdata and the pin Pcl connected to the integrated circuit bus of the electronic device 10, and reports the current of the battery 1a and the current of the battery 1b to the controller 15 through the IIC communication protocol. For example, the coulometer 30 is the sampling circuit 16 in FIG. 6. The pin Pdata and the pin Pcl are communication ends of the sampling circuit 16. The coulometer 30 may be configured to collect the value of the charging current I_{bat1} of the battery 11 in real time and report the value to the SoC. Alternatively, the coulometer 30 is the sampling circuit 1f in FIG. 10, the pin Pdata and the pin Pcl are communication ends of the sampling circuit 1f, and the coulometer 30 may be configured to collect the value of the charging current I_{bat1} of the battery 1a in real time and report the value to the SoC.

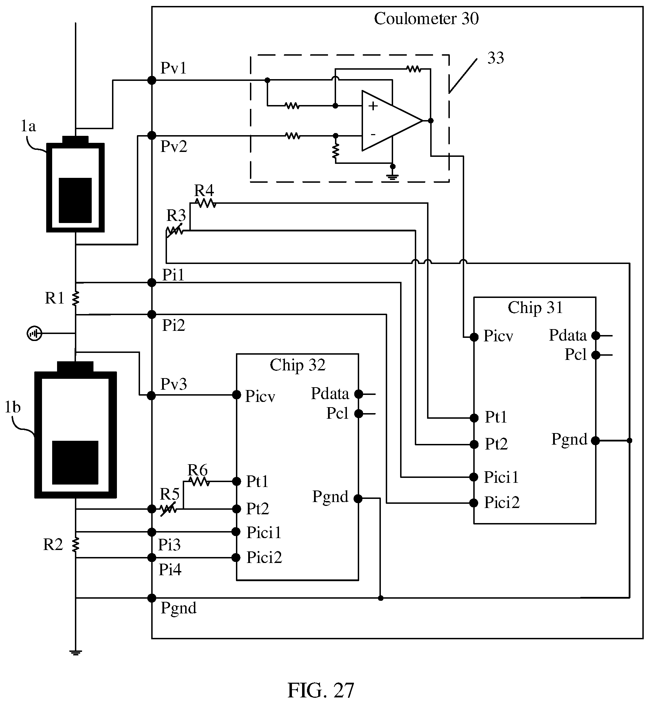

In some embodiments, the coulometer 30 is further configured to measure a temperature of the battery 1a and a temperature of the battery 1b. For example, as shown in FIG. 27, the chip 31 and the chip 32 each include a pin Pt1 and a pin Pt2, and the coulometer 30 further includes resistors R3, R4, R5, and R6. R3 has one terminal grounded (such as coupled to the pin Pdata of the chip 31) and the other terminal connected to the pin Pt2 of the chip 31. R4 has one terminal connected to the terminal of R3 that is connected to the pin Pt2 of the chip 31 and the other terminal connected to the pin Pt1 of the chip 31. R5 has one terminal connected to the negative electrode of the battery 1b (approximately considered to be grounded) and the other terminal connected to the pin Pt2 of the chip 32. R6 has one terminal connected to the terminal of R5 that is connected to the pin Pt2 of the chip 32 and the other terminal connected to the pin Pt1 of the chip 32. R3 and R5 are each a thermistor, for example, an NTC (negative temperature coefficient, negative temperature coefficient). R3 is disposed at a location close to the battery 1a (for example, in the battery pack of the battery 1a). R5 is disposed at a location close to the battery 1b (for example, in the battery pack of the battery 1b). In this way, the resistance values of R3 and R5 may change with changes in the battery temperature.

The pin Pt1 and the pin Pt2 of the chip 31 respectively collect the voltage values at the two terminals of the resistor R4, and a voltage difference between the two terminals of the resistor R4 is obtained. The resistor R3 has one terminal grounded, with a voltage value being 0 V. The pin Pt2 of the chip 31 collects a voltage value of the other terminal of the resistor R3, and obtains a voltage difference between the two terminals of the resistor R3. Referring to FIG. 27, Resistance value of R3/Resistance value of R4 = Voltage difference between two terminals of R3/Voltage difference between two terminals of R4. In this way, a current resistance value of R3 may be obtained based on the voltage values collected by the pin Pt1 and the pin Pt2 and the resistance value of the resistor R4. R3 is a thermistor, and a temperature value of R3 may be obtained based on the current resistance value of R3, that is, a temperature value of the battery 1a is obtained. Similarly, the pin Pt1 and the pin Pt2 of the chip 32 respectively collect the voltage values at the two terminals of the resistor R6, and a voltage difference between the two terminals of the resistor R6 is obtained. The resistor R5 has one terminal grounded (a voltage difference between the two terminals of R2 is very small and can be ignored), with a voltage value being 0 V. The pin Pt2 of the chip 32 collects a voltage value of the other terminal of the resistor R5, and obtains a voltage difference between the two terminals of the resistor R5. In this way, a current resistance value of R5 can be obtained based on the voltage values collected by the pin Pt1 and the pin Pt2 and a resistance value of the resistor R6, and a temperature value of R5 is obtained based on the current resistance value of R5, that is, a temperature value of the battery 1b is obtained.

Optionally, in an example, the coulometer 30 has the pin Pdata and the pin Pcl connected to the integrated circuit bus of the electronic device 10, and reports the temperature value of the battery 1a and the temperature value of the battery 1b to the controller 15 through the IIC communication protocol.

In an example, the chip 31 and the chip 32 are a same power management chip, for example, a coulometer.

Further, an electricity quantity of the battery 1a may be calculated based on the voltage, the current, and the temperature value of the battery 1a; and an electricity quantity of the battery 1b may be calculated based on the voltage, the current, and the temperature value of the battery 1b.

Common methods for calculating a battery electricity quantity (or state of charge) include an open-circuit voltage method (OCV) and a Coulomb counting method.

In the open-circuit voltage method, the remaining battery power is generally calculated by looking up a correspondence table of open-circuit voltages and states of charge of a battery. The open-circuit voltage is a battery voltage with a battery being in an idle state (neither charging nor discharging) for about more than half an hour. Battery voltage = OCV - IR, where I is a battery current, and R is a battery internal resistance. A voltage and a current of the battery is obtained by using a coulometer, and then, the battery electricity quantity can be obtained through a preset correspondence table of open-circuit voltages and states of charge. However, a larger I and a larger R indicate a larger difference between the battery voltage and the open-circuit voltage OCV, and a larger estimated error between the state of charge of the battery and the battery electricity quantity. In other words, both the battery internal resistance and a load current affect measurement accuracy, and the battery internal resistance is relatively highly discrete with the impact of the foregoing factors. Under different loads, temperatures, and aging states of the battery, the correspondence between open-circuit voltages and states of charge of the battery also changes. Therefore, during actual application, the battery voltage and the correspondence between open-circuit voltages and states of charge of the battery are usually further corrected based on an actual load, a current current value, and a temperature value of the battery, to obtain a more accurate battery electricity quantity (or state of charge). For a specific implementation method, refer to the conventional practice in the prior art. This is not limited in this embodiment of this application.

The Coulomb counting method, also referred to as an ampere-hour integration method, generally measures a current value of a battery charging or discharging, and then integrates the charging current value or discharging current value against a time (RTC) to obtain a quantity of coulombs charged or discharged. The method can accurately calculate a real-time state of charge of the battery charging or discharging. The current remaining electricity quantity RM and a full charge capacity FCC are calculated based on a previously remaining battery capacity. In this way, the state of charge is calculated by using the remaining capacity RM and the full charge capacity FCC, that is, State of charge = RM/FCC. In addition, the method can also estimate the remaining time, for example, the time to exhaustion (TTE) and the time to full (TTF).

Using a discharging process as an example, a measurement idea of the Coulomb counting method is to first obtain a maximum capacity of a battery at full charge, then integrate a discharging current in the discharging process with the time to obtain a discharge capacity, and subtract the discharge capacity from a full charge capacity to obtain the remaining capacity.

However, the method requires a complete discharge cycle to learn to determine the maximum capacity of the battery. Theoretically, it is updated when the battery is completely discharged. However, during actual application, due to the need to perform some operations such as a power off operation, some battery capacity needs to be reserved for this purpose. Therefore, the update is usually performed when the electricity quantity of the battery is 3% to 7% remaining. Using 7% as an example, this means that the battery has discharged 93% of the capacity. At the same time, integrating the discharging current with the time can obtain the discharged capacity (m Ah), and this is divided by 93% to obtain the full charge capacity of the battery.

Therefore, a key point in determining the full charge capacity is how to determine that the state of charge of the battery has reached 7%. This is generally determined based on the battery voltage, and the battery voltage is related to the current, temperature, impedance, and other factors at that time. This voltage can be defined as an end discharge voltage EDV, where EDV = OCV - IR. Generally, when the temperature and current are constant, and the battery internal resistance is not much different, the EDV is also basically constant. However, during actual application, the load current, temperature, and the like may change. In this case, the EDV obtained when the state of charge is 7% is different accordingly. Therefore, compensation needs to be performed based on the load current, temperature, and the like of the battery.

In addition, there may be deviations in the calculation of the electricity quantity using the Coulomb counting method.

Main reasons for the accuracy deviation caused by the use of the Coulomb counting method are as follow:

A first reason is the accumulation of deviations in current monitoring and ADC measurement (a coulometer collects a current through a pin). Any precision of ADC has an accuracy problem, and long-term operation causes the accumulation of such errors. If this has not been eliminated, a large deviation is caused. To eliminate the accumulation of errors, there are three possible time points in a normal operation for a battery: end of charge (EOC), end of discharge (EOD), and relax (RELAX). End of charge means that the battery is fully charged and the state of charge of the battery is 100%. End of discharge means that the battery has been completely discharged, and the state of charge of the battery is 0%. An end-of-charge state and an end-of-discharge state usually can be represented by using a voltage and a current of the battery. For example, a condition for satisfying the end-of-charge state is usually that the voltage of the battery is greater than a particular value and a current charging current is less than a cut-off current. Reaching a relax state means that there is no charging or discharging, which is also referred to as a light load state. Usually, such a state is maintained for more than half an hour, and in this case, the voltage of the battery is approximate to an open-circuit voltage of the battery.

A second reason is an error caused by a full charge electricity quantity of the battery, which is mainly a difference between a designed capacity value of the battery and a real battery capacity of the battery. In addition, the full charge electricity quantity is affected by a battery temperature, aging, load, and other factors, and compensation needs to be performed based on a load current, a temperature, and the like of the battery.

In addition, the electricity quantity may also be calculated by using a dynamic voltage method, an impedance tracking method, and other methods. During actual application, the electricity quantity of the battery may be calculated by using a method that can be obtained in a conventional technology. All in all, to accurately calculate the electricity quantity of the battery, a voltage, a current, and a temperature value of the battery need to be accurately obtained.

The coulometer provided in this embodiment of this application not only can be used to accurately measure voltage values, current values, and temperature values of two batteries when the two batteries are connected in series for charging; but also can be used to accurately measure voltage values, current values, and temperature values of two batteries when the two batteries are connected in parallel for discharging. Regardless of whether a circuit is switched to a state in which two batteries are connected in series for charging or to a state in which two batteries are connected in parallel for discharging, real-time electricity quantities of the two batteries can be accurately obtained. There is no need to change the connection relationship between the coulometer and the batteries, and there is no need to draw support from other auxiliary means. In addition, in terms of the coulometer provided in this embodiment of this application, the existing coulometer (the chip 31 and the chip 32) can be reused for transformation, thereby achieving simple implementation and low costs.

It should be noted that the coulometer 30 may further include more pins, such as interrupt pins (int), and the more pins can be achieved by using a common method that can be obtained by a person skilled in the art. This is not limited in this embodiment of this application.

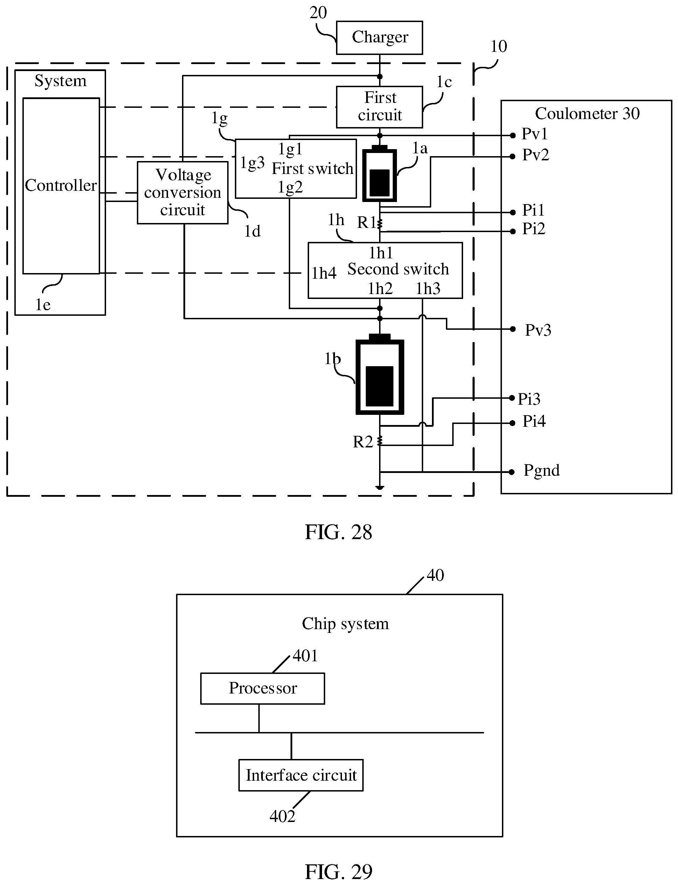

For example, FIG. 28 is a schematic diagram of a connection relationship obtained when an electricity quantity of a battery pack in the circuit shown in FIG. 13 is measured by using the coulometer 30. As shown in FIG. 28, the first controlled terminal 1g1 of the first switch 1g is coupled to the positive electrode of the battery 1a and the pin Pv1 of the coulometer 30 (the positive input terminal of the differential amplifier 33). The negative electrode of the battery 1a is coupled to the pin Pv2 of the coulometer 30 (the negative input terminal of the differential amplifier 33) and the pin Pi1 of the coulometer 30 (the pin Pici1 of the chip 31). The pin Pi2 of the coulometer 30 (the pin Pici2 of the chip 31) is coupled to the first controlled terminal 1h1 of the second switch 1h. The resistor R1 is connected between the first controlled terminal 1h1 of the second switch 1h and the negative electrode of the battery 1a.

The second controlled terminal 1g2 of the first switch 1g is coupled to the second controlled terminal 1h2 of the second switch 1h, the positive electrode of the battery 1b, and the pin Pv3 of the coulometer 30 (the pin Picv of the chip 32). The negative electrode of the battery 1b is coupled to the pin Pi3 of the coulometer 30 (the pin Pici1 of the chip 32). The third controlled terminal 1h3 of the second switch 1h is coupled to the pin Pi4 of the coulometer 30 (the pin Pici2 of the chip 32) and the pin Pgnd of the coulometer 30 and grounded. The resistor R2 is connected between the negative electrode of the battery 1b and a ground point.

When the first switch 1g is off, the first controlled terminal 1h1 of the second switch 1h is electrically connected to the second controlled terminal 1h2 and the first controlled terminal 1h1 is electrically disconnected from the third controlled terminal 1h3. In this way, the battery 1a and the battery 1b are connected in series.

When the first switch 1g is on, the first controlled terminal 1h1 of the second switch 1h is electrically disconnected from the second controlled terminal 1h2 and the first controlled terminal 1h1 is electrically connected to the third controlled terminal 1h3. In this way, the battery 1a and the battery 1b are connected in parallel.

The coulometer 30 may be configured to measure electricity quantities of the battery 1a and the battery 1b when the battery 1a and the battery 1b are connected in series, and may be further configured to measure electricity quantities of the battery 1a and the battery 1b when the battery 1a and the battery 1b are connected in parallel.

As shown in FIG. 29, an embodiment of this application further provides a chip system. The chip system 40 includes at least one processor 401 and at least one interface circuit 402. The at least one processor 401 and the at least one interface circuit 402 may be interconnected through a line. The processor 401 is configured to support an electronic device in implementing each function or step in the foregoing method embodiment. The at least one interface circuit 402 may be configured to receive a signal from another apparatus (for example, a memory), or send a signal to another apparatus (for example, a communication interface). The chip system may include a chip, and may further include another discrete device.

An embodiment of this application further provides a computer-readable storage medium, including instructions. The instructions, when run on the foregoing electronic device, cause the electronic device to perform each function or step in the foregoing method embodiment, for example, perform the method shown in FIG. 8, FIG. 11, or FIG. 21.

An embodiment of this application further provides a computer program product including instructions. The instructions, when run on the foregoing electronic device, cause the electronic device to perform each function or step in the foregoing method embodiment, for example, perform the method shown in FIG. 8, FIG. 11, or FIG. 21.

For technical effects of the chip system, the computer-readable storage medium, and the computer program product, refer to the technical effects of the foregoing method embodiments.

It should be understood that sequence numbers of the foregoing processes do not mean execution sequences in various embodiments of this application. The execution sequences of the processes should be determined according to functions and internal logic of the processes, and should not constitute any limitation on the implementation processes of the embodiments of this application.

A person of ordinary skill in the art may be aware that, in combination with the examples described in the embodiments disclosed in this specification, modules and algorithm steps may be implemented by electronic hardware or a combination of computer software and electronic hardware. Whether the functions are performed by hardware or software depends on particular applications and design constraint conditions of the technical solutions. A person skilled in the art can use different methods to implement the described functions for each particular application, but it should not be considered that such implementation goes beyond the scope of this application.

A person skilled in the art may clearly understand that, for the objective of convenient and brief description, for a detailed working process of the system, apparatus, and module described above, refer to a corresponding process in the method embodiments, and details are not described herein again.

In the several embodiments provided in this application, it should be understood that the disclosed system, device and method may be implemented in other manners. For example, the described device embodiments are merely examples. For example, division of the modules is merely logical function division and there may be other division manners during actual implementation. For example, a plurality of modules or components may be combined or integrated into another device, or some features may be ignored or not performed. In addition, the displayed or discussed mutual couplings or direct couplings or communication connections may be implemented by using some interfaces. The indirect couplings or communication connections between the devices or modules may be implemented in electronic, mechanical, or other forms.

The modules described as separate parts may or may not be physically separate, and parts displayed as modules may or may not be physical modules, may be located in one device, or may be distributed on a plurality of devices. Some or all of the modules may be selected according to actual needs to achieve the objectives of the solutions of the embodiments.

In addition, functional modules in the embodiments of this application may be integrated into one device, or each of the modules may exist alone physically, or two or more modules may be integrated into one device.

All or some of the foregoing embodiments may be implemented by using software, hardware, firmware, or any combination thereof. When a software program is used to implement the embodiments, the embodiments may be implemented completely or partially in a form of a computer program product. The computer program product includes one or more computer instructions. When the computer program instructions are loaded and executed on a computer, all or some of the processes or functions according to the embodiments of this application are produced. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid state disk (solid state disk, SSD)), or the like.

The foregoing descriptions are merely specific implementations of this application, but are not intended to limit the protection scope of this application. Therefore, the protection scope of this application should be subject to the protection scope of the claims.

## Claims

1. A power supply circuit, configured to charge/discharge a battery pack, wherein the battery pack comprises a first battery (1a) and a second battery (1b), a capacity of the first battery (1a) is a first value, a capacity of the second battery (1b) is a second value, the first value is less than the second value, and wherein the power supply circuit comprises a first circuit (1c), a second circuit (1d), a first switch (1g), and a second switch (1h);
the first circuit (1c) has one end coupled to a power supply terminal of a charger (20) and another end coupled to a positive electrode of the first battery (1a); a negative electrode of the first battery (1a) is coupled to a first controlled terminal (1h1) of the second switch (1h); a first controlled terminal (1g1) of the first switch (1g) is coupled to the positive electrode of the first battery (1a); a second controlled terminal (1g2) of the first switch (1g) is coupled to a second controlled terminal (1h2) of the second switch (1h) and a positive electrode of the second battery (1b); a third controlled terminal (1h3) of the second switch (1h) is coupled to a negative electrode of the second battery (1b); and the second circuit (1d) has one end coupled to the power supply terminal of the charger (20) and another end coupled to the positive electrode of the second battery (1b);
when the first switch (1g) is off, the first controlled terminal (1h1) of the second switch (1h) is electrically connected to the second controlled terminal (1h2) of the second switch (1h), the first controlled terminal (1h1) of the second switch (1h) is electrically disconnected from the third controlled terminal (1h3) of the second switch (1h), and when the first circuit (1c) is on, the first circuit (1c) and the second circuit (1d) are configured to supply power to the battery pack, wherein the first circuit (1c) is configured to input a first charging current to the first battery (1a); the first charging current of the first battery (1a) is output to the second battery (1b); the second circuit (1d) is configured to input a second charging current to the second battery (1b); a ratio of the first charging current input to the first battery (1a) to a third charging current input to the second battery (1b) is equal to a ratio of the first value to the second value; and the third charging current is a sum of the first charging current and the second charging current; and
when the first switch (1g) is on, the first controlled terminal (1h1) of the second switch (1h) is electrically disconnected from the second controlled terminal (1h2) of the second switch (1h), the first controlled terminal (1h1) of the second switch (1h) is electrically connected to the third controlled terminal (1h3) of the second switch (1h), and when the first circuit (1c) is off, the battery pack supplies power to the outside through the second circuit (1d).

2. The power supply circuit according to claim 1, wherein a value of the first charging current is a first current value, the power supply circuit further comprises a sampling circuit, one end of the sampling circuit is coupled to the negative electrode of the first battery (1a), and another end of the sampling circuit is coupled to the first controlled terminal (1h1) of the second switch (1h);
the sampling circuit is configured to detect a detection value of the first charging current; and
the first circuit (1c) is further configured to adjust an output current based on the detection value of the first charging current and the first current value, so that the value of the first charging current is the first current value.

3. The power supply circuit according to any one of claims 1 to 2, wherein the first circuit (1c) is a direct charging circuit, and the second circuit (1d) is a buck circuit.

4. An electronic device (10), comprising the power supply circuit according to claim 1 and the battery pack, wherein
when the first switch (1g) is on, the first controlled terminal (1h1) of the second switch (1h) is electrically disconnected from the second controlled terminal (1h2) of the second switch (1h), the first controlled terminal (1h1) of the second switch (1h) is electrically connected to the third controlled terminal (1h3) of the second switch (1h), and when the first circuit (1c) is off, the battery pack supplies power to a system of the electronic device (10) through the second circuit (1d).

5. The electronic device (10) according to claim 4, wherein a value of the first charging current is a first current value, and a value of the second charging current is a second current value; and the electronic device (10) further comprises a controller (1e), and
the controller (1e) is configured to send the first current value to the first circuit (1c); and is further configured to send the second current value to the second circuit (1d).

6. The electronic device (10) according to claim 5, wherein the electronic device (10) further comprises a sampling circuit, one end of the sampling circuit is coupled to the negative electrode of the first battery (1a), another end of the sampling circuit is coupled to the first controlled terminal (1h1) of the second switch (1h), and the sampling circuit is in communication connection with the first circuit (1c) through the controller (1e);
the sampling circuit is configured to detect a detection value of the first charging current; and
the first circuit (1c) is further configured to adjust an output current based on the detection value of the first charging current and the first current value, so that the value of the first charging current is the first current value.

7. The electronic device (10) according to claim 4, wherein a value of the first charging current is a first current value, the electronic device (10) further comprises a controller (1e) and a sampling circuit, one end of the sampling circuit is coupled to the negative electrode of the first battery (1a), and another end of the sampling circuit is coupled to the first controlled terminal (1h1) of the second switch (1h);
the sampling circuit is configured to detect a detection value of the first charging current;
the sampling circuit is further configured to send the detection value of the first charging current to the controller (1e); and
the controller (1e) is configured to control, based on the detection value of the first charging current and the first current value, the first circuit (1c) to adjust an output current, so that the value of the first charging current is the first current value.

8. The electronic device (10) according to any one of claims 5 to 7, wherein
the controller (1e) is configured to: when determining to supply power to the battery pack, control the first switch (1g) to be off, control the first controlled terminal (1h1) of the second switch (1h) to be electrically connected to the second controlled terminal (1h2) of the second switch (1h), control the first controlled terminal (1h1) of the second switch (1h) to be electrically disconnected from the third controlled terminal (1h3) of the second switch (1h), and control the first circuit (1c) to be on; and
the controller (1e) is further configured to: when determining that the battery pack supplies power to the system of the electronic device (10), control the first switch (1g) to be on, control the first controlled terminal (1h1) of the second switch (1h) to be electrically disconnected from the second controlled terminal (1h2) of the second switch (1h), control the first controlled terminal (1h1) of the second switch (1h) to be electrically connected to the third controlled terminal (1h3) of the second switch (1h), and control the first circuit (1c) to be off.

9. The electronic device (10) according to any one of claims 4 to 7, wherein the first circuit (1c) is a direct charging circuit, and the second circuit (1d) is a buck circuit.

10. A control method, applied to an electronic device (10), wherein the electronic device (10) comprises a first circuit (1c), a second circuit (1d), a first switch (1g), a second switch (1h), a controller (1e), and a battery pack; the battery pack comprises a first battery (1a) and a second battery (1b), a capacity of the first battery (1a) is a first value, a capacity of the second battery (1b) is a second value, the first value is less than the second value, and the first circuit (1c) has one end coupled to a power supply terminal of a charger (20) and another end coupled to a positive electrode of the first battery (1a); a negative electrode of the first battery (1a) is coupled to a first controlled terminal (1h1) of the second switch (1h); a first controlled terminal (1g1) of the first switch (1g) is coupled to the positive electrode of the first battery (1a); a second controlled terminal (1g2) of the first switch (1g) is coupled to a second controlled terminal (1h2) of the second switch (1h) and a positive electrode of the second battery (1b); a third controlled terminal (1h3) of the second switch (1h) is coupled to a negative electrode of the second battery (1b); the second circuit (1d) has one end coupled to the power supply terminal of the charger (20) and another end coupled to the positive electrode of the second battery (1b); and the method comprises:
determining, by the controller (1e), that the electronic device (10) is connected to the charger (20), controlling the first switch (1g) to be off, controlling the first controlled terminal (1h1) of the second switch (1h) to be electrically connected to the second controlled terminal (1h2) of the second switch (1h), controlling the first controlled terminal (1h1) of the second switch (1h) to be electrically disconnected from the third controlled terminal (1h3) of the second switch (1h), and controlling the first circuit (1c) to be on;
sending, by the controller (1e), a first current value to the first circuit (1c), and sending a second current value to the second circuit (1d);
inputting, by the first circuit (1c), a first charging current to the first battery (1a), wherein the first charging current of the first battery (1a) is output to the second battery (1b), and a value of the first charging current is the first current value; and
inputting, by the second circuit (1d), a second charging current to the second battery (1b), wherein a value of the second charging current is the second current value, wherein
a value of a third charging current input to the second battery (1b) is a third current value, and the third current value is a sum of the first current value and the second current value; and a ratio of the first current value to the third current value is equal to a ratio of the first value to the second value.

11. The method according to claim 10, wherein the electronic device (10) further comprises a sampling circuit, one end of the sampling circuit is coupled to the negative electrode of the first battery (1a), another end of the sampling circuit is coupled to the first controlled terminal (1h1) of the second switch (1h), and the method further comprises:
detecting, by the sampling circuit, a detection value of the first charging current, and sending the detection value of the first charging current to the controller (1e); and
controlling, by the controller (1e) based on the detection value of the first charging current and the first current value, the first circuit (1c) to adjust an output current, so that the value of the first charging current is the first current value.

12. The method according to claim 10 or 11, wherein the method further comprises:
determining, by the controller (1e), that the electronic device (10) is electrically disconnected from the charger (20), controlling the first switch (1g) to be on, controlling the first controlled terminal (1h1) of the second switch (1h) to be electrically disconnected from the second controlled terminal (1h2) of the second switch (1h), controlling the first controlled terminal (1h1) of the second switch (1h) to be electrically connected to the third controlled terminal (1h3) of the second switch (1h), and controlling the first circuit (1c) to be off; and
supplying, by the first battery (1a) and the second battery (1b), power to a system of the electronic device (10) through the second circuit (1d).

## Patentansprüche

1. Eine Stromversorgungsschaltung, konfiguriert zum Laden/Entladen eines Batteriepakets, wobei das Batteriepaket eine erste Batterie (1a) und eine zweite Batterie (1b) umfasst, die Kapazität der ersten Batterie (1a) einen ersten Wert aufweist, die Kapazität der zweiten Batterie (1b) einen zweiten Wert aufweist, der erste Wert geringer als der zweite Wert ist, und wobei die Stromversorgungsschaltung eine erste Schaltung (1c), eine zweite Schaltung (1d), einen ersten Schalter (1g) und einen zweiten Schalter (1h) umfasst;
die erste Schaltung (1c) ist mit einem Ende an einen Versorgungsklemmen eines Ladegeräts (20) und mit dem anderen Ende an die Plus-Elektrode der ersten Batterie (1a) angeschlossen; eine Minus-Elektrode der ersten Batterie (1a) ist an einen ersten gesteuerten Anschluss (1h1) des zweiten Schalters (1h) gekoppelt; ein erster gesteuerter Anschluss (1g1) des ersten Schalters (1g) ist mit der Plus-Elektrode der ersten Batterie (1a) gekoppelt; ein zweiter gesteuerter Anschluss (1g2) des ersten Schalters (1g) ist sowohl mit einem zweiten gesteuerten Anschluss (1h2) des zweiten Schalters (1h) als auch mit der Plus-Elektrode der zweiten Batterie (1b) verbunden; ein dritter gesteuerter Anschluss (1h3) des zweiten Schalters (1h) ist mit der Minus-Elektrode der zweiten Batterie (1b) gekoppelt; und die zweite Schaltung (1d) ist mit einem Ende an die Versorgungsklemmen des Ladegeräts (20) und mit dem anderen Ende an die Plus-Elektrode der zweiten Batterie (1b) angeschlossen;
wenn der erste Schalter (1g) geöffnet ist, ist der erste gesteuerte Anschluss (1h1) des zweiten Schalters (1h) elektrisch mit dem zweiten gesteuerten Anschluss (1h2) des zweiten Schalters (1h) verbunden, der erste gesteuerte Anschluss (1h1) des zweiten Schalters (1h) ist elektrisch vom dritten gesteuerten Anschluss (1h3) des zweiten Schalters (1h) getrennt, und wenn die erste Schaltung (1c) eingeschaltet ist, sind die erste Schaltung (1c) und die zweite Schaltung (1d) dazu ausgelegt, das Batteriepaket mit Strom zu versorgen, wobei die erste Schaltung (1c) dazu ausgelegt ist, einen ersten Ladestrom an die erste Batterie (1a) einzuspeisen; der erste Ladestrom der ersten Batterie (1a) wird an die zweite Batterie (1b) ausgegeben; die zweite Schaltung (1d) ist dazu ausgelegt, einen zweiten Ladestrom an die zweite Batterie (1b) einzuspeisen; das Verhältnis des ersten Ladestroms, der in die erste Batterie (1a) eingespeist wird, zu einem dritten Ladestrom, der in die zweite Batterie (1b) eingespeist wird, ist gleich dem Verhältnis des ersten Wertes zum zweiten Wert; und der dritte Ladestrom ist die Summe aus dem ersten und dem zweiten Ladestrom; und
wenn der erste Schalter (1g) geschlossen ist, ist der erste gesteuerte Anschluss (1h1) des zweiten Schalters (1h) elektrisch vom zweiten gesteuerten Anschluss (1h2) des zweiten Schalters (1h) getrennt, der erste gesteuerte Anschluss (1h1) des zweiten Schalters (1h) ist elektrisch mit dem dritten gesteuerten Anschluss (1h3) des zweiten Schalters (1h) verbunden, und wenn die erste Schaltung (1c) ausgeschaltet ist, stellt das Batteriepaket über die zweite Schaltung (1d) die Stromversorgung nach außen bereit.

2. Die Stromversorgungsschaltung gemäß Anspruch 1, wobei ein Wert des ersten Ladestroms ein erster Stromwert ist, wobei die Stromversorgungsschaltung ferner eine Abtastschaltung umfasst, wobei ein Ende der Abtastschaltung mit der negativen Elektrode der ersten Batterie (1a) verbunden ist und das andere Ende der Abtastschaltung mit dem ersten Steuerausgang (1h1) des zweiten Schalters (1h) verbunden ist;
die Abtastschaltung ist dazu eingerichtet, einen Messwert des ersten Ladestroms zu erfassen; und
die erste Schaltung (1c) ist ferner dazu eingerichtet, einen Ausgangsstrom basierend auf dem Messwert des ersten Ladestroms und dem ersten Stromwert anzupassen, sodass der Wert des ersten Ladestroms dem ersten Stromwert entspricht.

3. Die Stromversorgungsschaltung gemäß einem der Ansprüche 1 bis 2, wobei die erste Schaltung (1c) eine Direktladeschaltung ist und die zweite Schaltung (1d) eine Abwärtsschaltung ist.

4. Ein elektronisches Gerät (10), umfassend die Stromversorgungsschaltung gemäß Anspruch 1 und das Batteriepakt, wobei
wenn der erste Schalter (1g) eingeschaltet ist, ist der erste Steuerausgang (1h1) des zweiten Schalters (1h) elektrisch von dem zweiten Steuerausgang (1h2) des zweiten Schalters (1h) getrennt, der erste Steuerausgang (1h1) des zweiten Schalters (1h) ist elektrisch mit dem dritten Steuerausgang (1h3) des zweiten Schalters (1h) verbunden, und wenn die erste Schaltung (1c) ausgeschaltet ist, versorgt das Batteriepakt das System des elektronischen Geräts (10) über die zweite Schaltung (1d) mit Energie.

5. Das elektronische Gerät (10) gemäß Anspruch 4, wobei der Wert des ersten Ladestroms ein erster Stromwert ist und der Wert des zweiten Ladestroms ein zweiter Stromwert ist; und das elektronische Gerät (10) ferner einen Controller (1e) umfasst, und
der Controller (1e) ist dazu eingerichtet, den ersten Stromwert an die erste Schaltung (1c) zu senden; und ist ferner dazu eingerichtet, den zweiten Stromwert an die zweite Schaltung (1d) zu senden.

6. Das elektronische Gerät (10) gemäß Anspruch 5, wobei das elektronische Gerät (10) ferner eine Abtastschaltung umfasst, wobei ein Ende der Abtastschaltung mit der negativen Elektrode der ersten Batterie (1a) verbunden ist, das andere Ende der Abtastschaltung mit dem ersten Steuerausgang (1h1) des zweiten Schalters (1h) verbunden ist, und die Abtastschaltung über den Controller (1e) in Kommunikationsverbindung mit der ersten Schaltung (1c) steht;
die Abtastschaltung ist dazu eingerichtet, einen Messwert des ersten Ladestroms zu erfassen; und
Die erste Schaltung (1c) ist ferner dazu konfiguriert, einen Ausgangsstrom basierend auf dem erfassten Wert des ersten Ladestroms und dem ersten Stromwert anzupassen, so dass der Wert des ersten Ladestroms dem ersten Stromwert entspricht.

7. Das elektronische Gerät (10) nach Anspruch 4, wobei der Wert des ersten Ladestroms ein erster Stromwert ist, wobei das elektronische Gerät (10) ferner einen Controller (1e) und eine Abtastschaltung umfasst, wobei ein Ende der Abtastschaltung mit der negativen Elektrode der ersten Batterie (1a) gekoppelt ist und das andere Ende der Abtastschaltung mit dem ersten Steuerausgang (1h1) des zweiten Schalters (1h) verbunden ist;
Die Abtastschaltung ist dazu konfiguriert, einen Erfassungswert des ersten Ladestroms zu erkennen;
Die Abtastschaltung ist ferner dazu konfiguriert, den Erfassungswert des ersten Ladestroms an den Controller (1e) zu übermitteln; und
Der Controller (1e) ist dazu konfiguriert, basierend auf dem Erfassungswert des ersten Ladestroms und dem ersten Stromwert die erste Schaltung (1c) zur Anpassung eines Ausgangsstroms zu steuern, so dass der Wert des ersten Ladestroms dem ersten Stromwert entspricht.

8. Das elektronische Gerät (10) nach einem der Ansprüche 5 bis 7, wobei
Der Controller (1e) ist dazu konfiguriert, beim Feststellen der Stromversorgung des Batteriepacks folgende Steuerbefehle auszuführen: Den ersten Schalter (1g) auf AUS zu schalten, den ersten Steuerausgang (1h1) des zweiten Schalters (1h) elektrisch mit dem zweiten Steuerausgang (1h2) des zweiten Schalters (1h) zu verbinden, den ersten Steuerausgang (1h1) des zweiten Schalters (1h) elektrisch vom dritten Steuerausgang (1h3) des zweiten Schalters (1h) zu trennen und die erste Schaltung (1c) einzuschalten; und
Der Controller (1e) ist ferner dazu konfiguriert, beim Feststellen, dass das Batteriepack das System des elektronischen Geräts (10) mit Strom versorgt, folgende Steuerbefehle auszuführen: Den ersten Schalter (1g) einzuschalten, den ersten Steuerausgang (1h1) des zweiten Schalters (1h) elektrisch vom zweiten Steuerausgang (1h2) des zweiten Schalters (1h) zu trennen, den ersten Steuerausgang (1h1) des zweiten Schalters (1h) elektrisch mit dem dritten Steuerausgang (1h3) des zweiten Schalters (1h) zu verbinden und die erste Schaltung (1c) auszuschalten.

9. Das elektronische Gerät (10) nach einem der Ansprüche 4 bis 7, wobei die erste Schaltung (1c) eine Direktladeschaltung und die zweite Schaltung (1d) eine Abwärtsschaltung (Buck-Schaltung) ist.

10. Ein Steuerungsverfahren, angewendet auf ein elektronisches Gerät (10), wobei das elektronische Gerät (10) eine erste Schaltung (1c), eine zweite Schaltung (1d), einen ersten Schalter (1g), einen zweiten Schalter (1h), einen Controller (1e) und ein Batteriemodul umfasst; das Batteriemodul umfasst eine erste Batterie (1a) und eine zweite Batterie (1b), die Kapazität der ersten Batterie (1a) ist ein erster Wert, die Kapazität der zweiten Batterie (1b) ist ein zweiter Wert, der erste Wert ist kleiner als der zweite Wert, und die erste Schaltung (1c) ist mit einem Ende an einen Stromversorgungsanschluss eines Ladegeräts (20) und mit dem anderen Ende an den Pluspol der ersten Batterie (1a) gekoppelt; der Minuspol der ersten Batterie (1a) ist mit einem ersten gesteuerten Anschluss (1h1) des zweiten Schalters (1h) gekoppelt; ein erster gesteuerter Anschluss (1g1) des ersten Schalters (1g) ist mit dem Pluspol der ersten Batterie (1a) gekoppelt; ein zweiter gesteuerter Anschluss (1g2) des ersten Schalters (1g) ist sowohl mit einem zweiten gesteuerten Anschluss (1h2) des zweiten Schalters (1h) als auch mit dem Pluspol der zweiten Batterie (1b) gekoppelt; ein dritter gesteuerter Anschluss (1h3) des zweiten Schalters (1h) ist mit dem Minuspol der zweiten Batterie (1b) gekoppelt; die zweite Schaltung (1d) ist mit einem Ende an den Stromversorgungsanschluss des Ladegeräts (20) und mit dem anderen Ende an den Pluspol der zweiten Batterie (1b) gekoppelt; und das Verfahren umfasst:
dass der Controller (1e) feststellt, dass das elektronische Gerät (10) mit dem Ladegerät (20) verbunden ist, den ersten Schalter (1g) ausschaltet, den ersten gesteuerten Anschluss (1h1) des zweiten Schalters (1h) elektrisch mit dem zweiten gesteuerten Anschluss (1h2) des zweiten Schalters (1h) verbindet, den ersten gesteuerten Anschluss (1h1) des zweiten Schalters (1h) elektrisch vom dritten gesteuerten Anschluss (1h3) des zweiten Schalters (1h) trennt und die erste Schaltung (1c) einschaltet;
der Controller (1e) sendet einen ersten Stromwert an die erste Schaltung (1c) und einen zweiten Stromwert an die zweite Schaltung (1d);
die erste Schaltung (1c) speist einen ersten Ladestrom in die erste Batterie (1a) ein, wobei der erste Ladestrom der ersten Batterie (1a) an die zweite Batterie (1b) weitergeleitet wird und der Wert des ersten Ladestroms dem ersten Stromwert entspricht; und
die zweite Schaltung (1d) speist einen zweiten Ladestrom in die zweite Batterie (1b) ein, wobei der Wert des zweiten Ladestroms dem zweiten Stromwert entspricht, wobei
ein Wert eines dritten Ladestroms, der in die zweite Batterie (1b) eingespeist wird, ein dritter Stromwert ist, und der dritte Stromwert ist die Summe des ersten Stromwerts und des zweiten Stromwerts; und das Verhältnis des ersten Stromwerts zum dritten Stromwert ist gleich dem Verhältnis des ersten Werts zum zweiten Wert.

11. Verfahren nach Anspruch 10, wobei das elektronische Gerät (10) ferner eine Abtastschaltung umfasst, wobei ein Ende der Abtastschaltung mit dem Minuspol der ersten Batterie (1a) verbunden ist, das andere Ende der Abtastschaltung mit dem ersten Steueranschluss (1h1) des zweiten Schalters (1h) verbunden ist und das Verfahren ferner umfasst:
Erfassung eines Messwerts des ersten Ladestroms durch die Abtastschaltung und Übermittlung des Messwerts des ersten Ladestroms an den Regler (1e); und
Steuerung der ersten Schaltung (1c) durch den Regler (1e) auf Basis des Messwerts des ersten Ladestroms und des ersten Stromwerts zur Anpassung des Ausgangsstroms, sodass der Wert des ersten Ladestroms dem ersten Stromwert entspricht.

12. Verfahren nach Anspruch 10 oder 11, wobei das Verfahren ferner umfasst:
Feststellung durch den Regler (1e), dass das elektronische Gerät (10) elektrisch vom Ladegerät (20) getrennt ist, Steuerung des ersten Schalters (1g) zum Einschalten, Steuerung des ersten Steueranschlusses (1h1) des zweiten Schalters (1h) zur elektrischen Trennung vom zweiten Steueranschluss (1h2) des zweiten Schalters (1h), Steuerung des ersten Steueranschlusses (1h1) des zweiten Schalters (1h) zur elektrischen Verbindung mit dem dritten Steueranschluss (1h3) des zweiten Schalters (1h) und das Ausschalten der ersten Schaltung (1c); und
Versorgung des Systems des elektronischen Geräts (10) durch die erste Batterie (1a) und die zweite Batterie (1b) über die zweite Schaltung (1d) mit Strom.

## Revendications

1. Un circuit d'alimentation électrique, configuré pour charger/décharger un bloc-batterie, ledit bloc-batterie comprenant une première batterie (1a) et une seconde batterie (1b), la capacité de la première batterie (1a) étant une première valeur, la capacité de la seconde batterie (1b) étant une seconde valeur, la première valeur étant inférieure à la seconde valeur, et le circuit d'alimentation électrique comprenant un premier circuit (1c), un second circuit (1d), un premier interrupteur (1g), et un second interrupteur (1h) ;
le premier circuit (1c) a une extrémité connectée à une borne d'alimentation d'un chargeur (20) et une autre extrémité connectée à l'électrode positive de la première batterie (1a) ; l'électrode négative de la première batterie (1a) est connectée à une première borne commandée (1h1) du second interrupteur (1h) ; une première borne commandée (1g1) du premier interrupteur (1g) est connectée à l'électrode positive de la première batterie (1a) ; une seconde borne commandée (1g2) du premier interrupteur (1g) est connectée à une seconde borne commandée (1h2) du second interrupteur (1h) et à l'électrode positive de la seconde batterie (1b) ; une troisième borne commandée (1h3) du second interrupteur (1h) est connectée à l'électrode négative de la seconde batterie (1b) ; et le second circuit (1d) a une extrémité connectée à la borne d'alimentation du chargeur (20) et une autre extrémité connectée à l'électrode positive de la seconde batterie (1b) ;
lorsque le premier interrupteur (1g) est ouvert, la première borne commandée (1h1) du second interrupteur (1h) est électriquement connectée à la seconde borne commandée (1h2) du second interrupteur (1h), la première borne commandée (1h1) du second interrupteur (1h) est électriquement déconnectée de la troisième borne commandée (1h3) du second interrupteur (1h), et lorsque le premier circuit (1c) est fermé, le premier circuit (1c) et le second circuit (1d) sont configurés pour alimenter le bloc-batterie, où le premier circuit (1c) est configuré pour injecter un premier courant de charge dans la première batterie (1a) ; le premier courant de charge de la première batterie (1a) est envoyé dans la seconde batterie (1b) ; le second circuit (1d) est configuré pour injecter un second courant de charge dans la seconde batterie (1b) ; le rapport entre le premier courant de charge injecté dans la première batterie (1a) et un troisième courant de charge injecté dans la seconde batterie (1b) est égal au rapport de la première valeur sur la seconde valeur ; et le troisième courant de charge est égal à la somme du premier courant de charge et du second courant de charge ; et
lorsque le premier interrupteur (1g) est fermé, la première borne commandée (1h1) du second interrupteur (1h) est électriquement déconnectée de la seconde borne commandée (1h2) du second interrupteur (1h), la première borne commandée (1h1) du second interrupteur (1h) est électriquement connectée à la troisième borne commandée (1h3) du second interrupteur (1h), et lorsque le premier circuit (1c) est ouvert, le bloc-batterie alimente l'extérieur via le second circuit (1d).

2. Le circuit d'alimentation selon la revendication 1, dans lequel une valeur du premier courant de charge est une première valeur de courant, le circuit d'alimentation comprenant en outre un circuit d'échantillonnage, une extrémité du circuit d'échantillonnage étant couplée à l'électrode négative de la première batterie (1a), et une autre extrémité du circuit d'échantillonnage étant couplée à la première borne de commande (1h1) du second interrupteur (1h) ;
le circuit d'échantillonnage est conçu pour détecter une valeur de détection du premier courant de charge ; et
le premier circuit (1c) est en outre conçu pour ajuster un courant de sortie en fonction de la valeur de détection du premier courant de charge et de la première valeur de courant, de sorte que la valeur du premier courant de charge soit la première valeur de courant.

3. Le circuit d'alimentation selon l'une quelconque des revendications 1 à 2, dans lequel le premier circuit (1c) est un circuit de charge directe, et le second circuit (1d) est un circuit abaisseur.

4. Un dispositif électronique (10), comprenant le circuit d'alimentation selon la revendication 1 et le bloc-piles, dans lequel
lorsque le premier interrupteur (1g) est fermé, la première borne de commande (1h1) du second interrupteur (1h) est électriquement déconnectée de la seconde borne de commande (1h2) du second interrupteur (1h), la première borne de commande (1h1) du second interrupteur (1h) est électriquement connectée à la troisième borne de commande (1h3) du second interrupteur (1h), et lorsque le premier circuit (1c) est hors tension, le bloc-piles alimente un système du dispositif électronique (10) via le second circuit (1d).

5. Le dispositif électronique (10) selon la revendication 4, dans lequel une valeur du premier courant de charge est une première valeur de courant, et une valeur du second courant de charge est une seconde valeur de courant ; et le dispositif électronique (10) comprend en outre un contrôleur (1e), et
le contrôleur (1e) est conçu pour envoyer la première valeur de courant au premier circuit (1c) ; et est en outre conçu pour envoyer la seconde valeur de courant au second circuit (1d).

6. Le dispositif électronique (10) selon la revendication 5, dans lequel le dispositif électronique (10) comprend en outre un circuit d'échantillonnage, une extrémité du circuit d'échantillonnage étant couplée à l'électrode négative de la première batterie (1a), une autre extrémité du circuit d'échantillonnage étant couplée à la première borne de commande (1h1) du second interrupteur (1h), et le circuit d'échantillonnage est connecté en communication avec le premier circuit (1c) via le contrôleur (1e) ;
le circuit d'échantillonnage est conçu pour détecter une valeur de détection du premier courant de charge ; et
le premier circuit (1c) est en outre configuré pour ajuster un courant de sortie en fonction de la valeur détectée du premier courant de charge et de la première valeur de courant, de sorte que la valeur du premier courant de charge soit la première valeur de courant.

7. Dispositif électronique (10) selon la revendication 4, dans lequel une valeur du premier courant de charge est une première valeur de courant, le dispositif électronique (10) comprenant en outre un contrôleur (1e) et un circuit d'échantillonnage, une extrémité du circuit d'échantillonnage étant couplée à l'électrode négative de la première batterie (1a), et l'autre extrémité du circuit d'échantillonnage étant couplée à la première borne commandée (1h1) du second interrupteur (1h) ;
le circuit d'échantillonnage est configuré pour détecter une valeur détectée du premier courant de charge ;
le circuit d'échantillonnage est en outre configuré pour envoyer la valeur détectée du premier courant de charge au contrôleur (1e) ; et
le contrôleur (1e) est configuré pour, sur la base de la valeur détectée du premier courant de charge et de la première valeur de courant, commander au premier circuit (1c) d'ajuster un courant de sortie, de sorte que la valeur du premier courant de charge soit la première valeur de courant.

8. Dispositif électronique (10) selon l'une quelconque des revendications 5 à 7, dans lequel
le contrôleur (1e) est configuré pour : lorsqu'il détermine qu'il faut alimenter le bloc-batterie, commander l'ouverture du premier interrupteur (1g), connecter électriquement la première borne commandée (1h1) du second interrupteur (1h) à la seconde borne commandée (1h2) du second interrupteur (1h), déconnecter électriquement la première borne commandée (1h1) du second interrupteur (1h) de la troisième borne commandée (1h3) du second interrupteur (1h), et activer le premier circuit (1c); et
le contrôleur (1e) est en outre configuré pour : lorsqu'il détermine que le bloc-batterie alimente le système du dispositif électronique (10), activer le premier interrupteur (1g), déconnecter électriquement la première borne commandée (1h1) du second interrupteur (1h) de la seconde borne commandée (1h2) du second interrupteur (1h), connecter électriquement la première borne commandée (1h1) du second interrupteur (1h) à la troisième borne commandée (1h3) du second interrupteur (1h), et désactiver le premier circuit (1c).

9. Dispositif électronique (10) selon l'une quelconque des revendications 4 à 7, dans lequel le premier circuit (1c) est un circuit de charge directe, et le second circuit (1d) est un circuit abaisseur (buck).

10. Un procédé de contrôle, appliqué à un dispositif électronique (10), ledit dispositif électronique (10) comprenant un premier circuit (1c), un second circuit (1d), un premier interrupteur (1g), un second interrupteur (1h), un contrôleur (1e) et un bloc batterie ; le bloc batterie comprenant une première batterie (1a) et une seconde batterie (1b), la capacité de la première batterie (1a) étant une première valeur, la capacité de la seconde batterie (1b) étant une seconde valeur, la première valeur étant inférieure à la seconde valeur, et le premier circuit (1c) ayant une extrémité couplée à une borne d'alimentation d'un chargeur (20) et une autre extrémité couplée à l'électrode positive de la première batterie (1a) ; une électrode négative de la première batterie (1a) est couplée à une première borne commandée (1h1) du second interrupteur (1h) ; une première borne commandée (1g1) du premier interrupteur (1g) est couplée à l'électrode positive de la première batterie (1a) ; une seconde borne commandée (1g2) du premier interrupteur (1g) est couplée à une seconde borne commandée (1h2) du second interrupteur (1h) et à l'électrode positive de la seconde batterie (1b) ; une troisième borne commandée (1h3) du second interrupteur (1h) est couplée à l'électrode négative de la seconde batterie (1b) ; le second circuit (1d) ayant une extrémité couplée à la borne d'alimentation du chargeur (20) et une autre extrémité couplée à l'électrode positive de la seconde batterie (1b) ; et le procédé comprend :
déterminer, par le contrôleur (1e), que le dispositif électronique (10) est connecté au chargeur (20), commander la coupure du premier interrupteur (1g), commander la connexion électrique de la première borne commandée (1h1) du second interrupteur (1h) à la seconde borne commandée (1h2) du second interrupteur (1h), commander la déconnexion électrique de la première borne commandée (1h1) du second interrupteur (1h) de la troisième borne commandée (1h3) du second interrupteur (1h), et commander la mise en service du premier circuit (1c) ;
envoyer, par le contrôleur (1e), une première valeur de courant au premier circuit (1c), et envoyer une seconde valeur de courant au second circuit (1d) ;
injecter, par le premier circuit (1c), un premier courant de charge à la première batterie (1a), ledit premier courant de charge de la première batterie (1a) étant délivré à la seconde batterie (1b), et la valeur du premier courant de charge correspondant à la première valeur de courant ; et
injecter, par le second circuit (1d), un second courant de charge à la seconde batterie (1b), la valeur du second courant de charge correspondant à la seconde valeur de courant, dans lequel
une valeur d'un troisième courant de charge injecté à la seconde batterie (1b) correspond à une troisième valeur de courant, et la troisième valeur de courant est la somme de la première valeur de courant et de la seconde valeur de courant ; et le rapport entre la première valeur de courant et la troisième valeur de courant est égal au rapport entre la première valeur et la seconde valeur.

11. Le procédé selon la revendication 10, dans lequel le dispositif électronique (10) comprend en outre un circuit d'échantillonnage, une extrémité du circuit d'échantillonnage étant couplée à l'électrode négative de la première batterie (1a), une autre extrémité du circuit d'échantillonnage étant couplée à la première borne de commande (1h1) du deuxième commutateur (1h), et le procédé comprend en outre :
la détection, par le circuit d'échantillonnage, d'une valeur de détection du premier courant de charge et l'envoi de cette valeur de détection du premier courant de charge au contrôleur (1e) ; et
le contrôle, par le contrôleur (1e), sur la base de la valeur de détection du premier courant de charge et de la première valeur de courant, du premier circuit (1c) afin d'ajuster un courant de sortie, de sorte que la valeur du premier courant de charge soit la première valeur de courant.

12. Le procédé selon la revendication 10 ou 11, dans lequel le procédé comprend en outre :
la détermination, par le contrôleur (1e), que le dispositif électronique (10) est électriquement déconnecté du chargeur (20), le contrôle de la mise sous tension du premier commutateur (1g), le contrôle de la déconnexion électrique de la première borne de commande (1h1) du deuxième commutateur (1h) de la deuxième borne de commande (1h2) du deuxième commutateur (1h), le contrôle de la connexion électrique de la première borne de commande (1h1) du deuxième commutateur (1h) à la troisième borne de commande (1h3) du deuxième commutateur (1h), et le contrôle de la mise hors tension du premier circuit (1c) ; et
l'alimentation, par la première batterie (1a) et la deuxième batterie (1b), du système du dispositif électronique (10) via le deuxième circuit (1d).
